(19) Europäisches Patentamt
European Patent Office
Office européen des brevets

(11) EP 4 382 551 A1

(12) **EUROPEAN PATENT APPLICATION**

(43) Date of publication:
**12.06.2024 Bulletin 2024/24**

(21) Application number: **23212936.1**

(22) Date of filing: **29.11.2023**

(51) International Patent Classification (IPC):
***C08G 73/02*** *(2006.01)* ***C08K 5/09*** *(2006.01)*
***C08K 5/19*** *(2006.01)* ***C08L 39/06*** *(2006.01)*
***C08L 79/02*** *(2006.01)* ***G03F 7/00*** *(2006.01)*

(52) Cooperative Patent Classification (CPC):
(C-Sets available)
**C08G 73/0266; C08G 73/026; C08L 39/06; C08L 79/02; G03F 7/00** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **09.12.2022 JP 2022197392**

(71) Applicant: **SHIN-ETSU CHEMICAL CO., LTD.**
**Tokyo 1000005 (JP)**

(72) Inventors:
- **Nagasawa, Takayuki**
  **Niigata (JP)**
- **Watanabe, Satoshi**
  **Niigata (JP)**
- **Matsuzawa, Yuta**
  **Niigata (JP)**
- **Kotake, Masaaki**
  **Niigata (JP)**
- **Masunaga, Keiichi**
  **Niigata (JP)**

(74) Representative: **Sonnenhauser, Thomas Martin**
**Wuesthoff & Wuesthoff**
**Patentanwälte und Rechtsanwalt PartG mbB**
**Schweigerstraße 2**
**81541 München (DE)**

# (54) CONDUCTIVE POLYMER COMPOSITION, COATED PRODUCT, AND PATTERNING PROCESS

(57) The present invention is a conductive polymer composition containing: (A) a polyaniline-based conductive polymer having at least one repeating unit of the formula (1); and (B) a hydrogencarbonate including a cation of the formula (2-1) or (2-2). Here, $R_1$ to $R_4$ each represent a hydrogen atom, an acidic group, a hydroxy group, a nitro group, a halogen atom, a linear or branched alkyl group, a hydrocarbon group containing a hetero atom, or a hydrocarbon group partially substituted with a halogen atom. X represents a monovalent alkali metal selected from lithium, sodium, potassium, and cesium, $R^{101}$ to $R^{104}$ each represent a hydrogen atom, an alkyl group, an alkenyl group, an oxoalkyl group, an oxoalkenyl group, an aryl group, an aralkyl group, or an aryloxoalkyl group. $R^{101}$ and $R^{102}$, $R^{103}$ and $R^{104}$, and $R^{101}$, $R^{102}$, and $R^{104}$ optionally form a ring. This provides a conductive polymer composition that can form an antistatic film for electron beam resist writing.

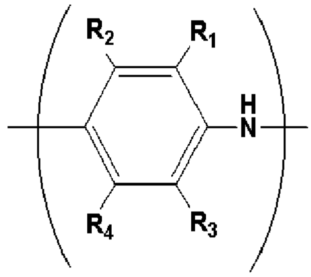

(1)

$X^+$ (2-1)

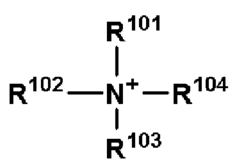

(2-2)

EP 4 382 551 A1

(52) Cooperative Patent Classification (CPC): (Cont.)

C-Sets
**C08K 3/26, C08L 79/02;**
**C08K 5/19, C08L 79/02;**
**C08L 79/02, C08K 5/09, C08L 39/06,**
**C08L 71/00;**
C08K 5/09, C08L 79/02

## Description

TECHNICAL FIELD

The present invention relates to: a conductive polymer composition containing a polyaniline-based conductive polymer; a coated product using the same; and a patterning process using the same.

BACKGROUND ART

In a manufacturing process of a mask for a semiconductor device such as an IC, an LSI, etc., fine processing by a lithography method using an electron beam resist has been conventionally carried out. This is a method in which a substrate is subjected to etching in accordance with a resist pattern obtained by the results that a crosslinking or decomposition reaction of components in a written portion is induced by irradiation of a resist film with an electron beam to change the solubility in the written portion remarkably, and that the film is subjected to development by a solvent and the like. Accompanied by high integration of semiconductor devices, high-precision fine processing using short-wavelength light beam with EUV has come to be required in recent years. Accordingly, finer processing using an electron beam resist of an exposure mask is also required.

Problems peculiar to lithography using an electron beam include charging phenomenon (charge-up) at the time of exposure. This is a phenomenon in which charges accumulate on or in a resist film and become charged when a substrate to be subjected to electron beam exposure is covered with the insulating resist film. Due to this charging, the orbital of the electron beam continuously entering the film is bent due to electrostatic repulsion, so that a depicting accuracy is significantly reduced as a result. Therefore, adoption of a peelable antistatic film to be applied onto an electron beam resist has been investigated.

In the above-described electron beam resist lithography by the electron beam, the positional accuracy of electron beam writing has become more important, accompanying miniaturization of semiconductor devices. Writing technology is being developed from the conventional technology of single-beam mask writing to multi-beam mask writing. However, the writing position correction (guaranteeing positional accuracy) that arises from electrostatic repulsion caused by the resist being charged at the time of writing is still a significant problem. As a measure to counter the problem, the development of an antistatic film (CDL: Charge Dissipation Layer) to be formed on an electron beam resist is progressing.

Properties necessary in the antistatic film (CDL) include: applicability on an electron beam resist; ability to form a thin film; high-efficiency diffusion property for a charge charged during writing; low chemical effects on an electron beam resist underneath at the time of and after film formation; ease of delamination immediately after writing with an electron beam or after a resist heat treatment after writing (PEB); low-defect property; etc. As a composition that has all the above properties, a composition containing a conductive polymer as a base and $H_2O$ as a main solvent is being studied.

Patent Document 1 discloses that in order to reduce lowering in writing accuracy due to the above-described charging phenomenon on a resist, a conductive polymer film formed by coating the resist with a composition of a material in which an acidic substituent is introduced in the structure of a π-conjugated conductive polymer shows an antistatic effect at the time of electron beam writing. It is also clearly shown that the conductive polymer film maintains water solubility even after the electron beam writing at a high irradiation dose so that it is possible to remove the conductive polymer film by washing with water.

Patent Document 2 discloses a composition containing a polyaniline-based conductive polymer, a polyacid, and $H_2O$, and it is clearly shown that a complex containing the polyaniline-based conductive polymer and the polyacid is capable of forming a good film by spin-coating with 5 to 10 mass%, and can form an antistatic film in which antistatic effect can be observed with a film thickness of 150 nm and peeling and washing with $H_2O$ is possible.

Patent Document 3 discloses a technique of using a polythiophene-based conductive polymer as an antistatic film for electron beam lithography, and shows an antistatic film function of a complex containing the polythiophene-based conductive polymer and a polyanion by the effect of adding a gemini type surfactant and the like.

In Patent Document 4, a compound which is subjected to self-doping in a polyaniline molecule has been newly proposed by replacing at least one among H atoms of a benzene ring skeleton of an aniline which is a repeating unit of a polyaniline-based conductive polymer with an acidic group. The polyaniline-based conductive polymer of Patent Document 2 or 3 is a complex containing an aniline oligomer which is a π-conjugated system polymer that controls carrier transfer, and a monomer or a polymer having a sulfonic acid terminal that is called a dopant, and is dispersed in $H_2O$ showing a particle-like behavior therein, so that for subjecting to homogenization of the material, it is necessary to carry out a treatment with a high output homogenizer or a high pressure disperser, and further, after coating an electron beam resist, a process for removing particle aggregates which become a defect of pattern writing is complicated. On the other hand, the compound described in Patent Document 4 is converted into a solvate with $H_2O$ to show molecular behavior, so that the above-described defect factor can be dramatically reduced only by simple filtration.

Patent Document 5 proposes, in paragraphs 0045 to 0048, adding a strong basic compound to a composition

containing a self-doping compound in a polyaniline molecule for the purpose of neutralizing $H^+$ in order to avoid the adverse effect, on a resist pattern, of $H^+$ generated from acidic groups other than acidic groups consumed as a dopant by a polyaniline main chain. As basic compounds, mentioned are ammonium salts of hydroxides, such as tetrapropylammonium hydroxide, tetrabutylammonium hydroxide, tetrapentylammonium hydroxide, tetrahexylammonium hydroxide, and benzyltrimethylammonium hydroxide, 1,5-diazabicyclo-[4.3.0]-5-nonene (DBN), 1,8-diazabicyclo[5.4.0]-7-undecene (DBU) and a derivative thereof. Since the hydroxide has strong basicity, the hydroxide neutralizes efficiently the $H^+$ derived from polyaniline. However, at the same time, the hydroxide has nucleophilicity, and therefore, de-doping of the conductive polymer or a side reaction occurs in some cases if the hydroxide remains in the film. The side reaction is, for example, as follows. An acid generator and the like contained in an EB resist is a salt often containing an ester bond in the structure as a linker, and near the interface between the antistatic film and the resist film or in an upper layer of a resist layer, the ester bond is subjected to nucleophilic attack by a strong basic compound, and a moiety imparted with functions such as diffusion control and dissolution characteristics is eliminated. Therefore, diffusion of the salt ions of an acid generator which became small molecules is promoted after irradiation with the electron beam, and as a result, sensitivity fluctuation and pattern failure occur in lithography. Although 1,5-diazabicyclo[4.3.0]-5-nonene (DBN) and 1,8-diazabicyclo[5.4.0]-7-undecene (DBU) are strong bases, they have weak nucleophilicity so that it can be considered that nucleophilic attack to the ester bond hardly occurs even if the bases remain in the film. However, the bases are small molecules, and when the conductive composition is formed as a film on the EB resist, diffusion of the bases from the interface to the resist layer occurs and the acid generated from the acid generator after electron beam writing is quenched. As a result, there is a problem that sensitivity fluctuation and pattern failure occur in lithography.

Patent Document 6 proposes adding a carboxylate to a composition containing a self-doping compound in a polyaniline molecule in order to avoid the adverse effect, on a resist pattern, of $H^+$ generated from acidic groups other than acidic groups consumed as a dopant by a polyaniline main chain. When the acidic group is a sulfonic acid group, and when a salt of a carboxylic acid, which is a weak acid, is present in the vicinity or in a high concentration, salt exchange occurs due to a difference in pKa, and part of the $H^+$ is taken in as carboxylic acid, reducing the proportion of polyaniline-derived $H^+$ that affects the resist layer. This effect makes it possible to maintain high resolution in resist lithography and control degradation in Post Coating Delay (PCD). However, carboxylic acid is a weak acid, and does not cause a neutralization reaction like a basic substance. Therefore, the pH of the entire composition is in a weak acid region even after salt exchange, and depending on the properties of the resist, it is possible that the effect of $H^+$ from the interface to the resist layer cannot be controlled completely. In addition, when dissociation equilibrium is to be adjusted by the concentration of the carboxylic acid, increasing the amount to be added causes resistance in electron transfer between polyaniline molecules, and causes degradation in the conductivity of the composition. Therefore, there is a limit to the amount that can be added.

## CITATION LIST

### PATENT LITERATURE

Patent Document 1: JP 2902727 B2
Patent Document 2: US 5,370,825 A
Patent Document 3: JP 2014-009342 A
Patent Document 4: JP 3631910 B2
Patent Document 5: JP 2017-39927 A
Patent Document 6: JP 7108565 B2


## SUMMARY OF INVENTION

### TECHNICAL PROBLEM

As the polyaniline compounds shown in Patent Documents 1, 4, 5, and 6, those in which an acidic substituent is introduced into the structure of a monomer unit of a $\pi$-conjugated conductive polymer are used, and take forms in which the acidic substituent is self-doped in the $\pi$-conjugated conductive polymer chain. However, not all the acidic substituents existing in the $\pi$-conjugated conductive polymer after polymerization are doped in the $\pi$-conjugated system, but these are partly present in the polymer in the form of an acid or a salt thereof. In the state of the acid, the polyaniline is formed as an antistatic film on the electron beam resist at the time of electron beam irradiation, and the acid diffuses into the resist layer to exert adverse effects on lithography. If a strong base is added as a neutralizing agent for the purpose of controlling the diffusion of the acid, handling itself is dangerous, and moreover, the optimum neutralization

of the polymer composition itself is difficult. If the amount of the strong base present is more than the amount that is consumed in the neutralization, the strong base gradually permeates through the resist film, and acts as a quencher of the acid generated from an acid generator of the resist. On the other hand, if the strong base has nucleophilicity, the strong base causes nucleophilic attack and so forth on an ester bond moiety etc. of a component contained in the resist composition. As a result, fluctuation in sensitivity and pattern failure occur in lithography.

The effect of the strong base on the resist is remarkably exhibited in a test of storage stability, which is called PCD (Post Coating Delay), in the state of an antistatic film formed on the resist without irradiating with the electron beam. That is, a strongly basic substance existing in the antistatic film gradually penetrates and diffuses into the resist film during storage in an unirradiated state. Since no writing has been performed, an excessive quenching effect of an acid generated from the resist does not occur, but the strong base makes a nucleophilic attack to the resist polymer or the acid generator at any time to cut a linker bonding portion of the resist, and cuts off an acid terminal of an electron beam acid generator. In the electron beam writing thereafter, an acid is generated. The acid, being a small molecule, reacts with the resist polymer at a higher diffusion rate than the acid inherently generated from the acid generator during PEB, and causes remarkable sensitivity change, film loss, and pattern degradation in lithography.

In general, a polyaniline using an unsubstituted aniline as a raw material shows high conductivity, but has low hydrophilicity and poor dispersibility in $H_2O$, so that film-formability on a substrate is extremely bad. On the other hand, in the composition described in Patent Document 2, in a complex containing a polyaniline-based conductive polymer which is to be a base polymer and a polyacid, by introducing a hydrophilic substituent into the aniline skeleton, dispersibility of the polyaniline complex in $H_2O$ and film-formability on a substrate are improved, and quick response is shown in the peeling and washing process by $H_2O$. However, introducing a substituent into the aniline skeleton makes it difficult for high conductivity to be exhibited in some cases, due to the properties and bulkiness of the substituent, degradation in the degree of polymerization, etc. If a rise in resistivity occurs parallel to a rise in solubility in water, sufficient dispersion of the electric charge charged in the resist layer cannot be achieved, even if peelability by water washing can be secured.

In the $\pi$-conjugated conductive polymer, as a material which is used for the antistatic film use in a writing process of the electron beam lithography, there is a polythiophene-based conductive polymer besides the polyaniline-based conductive polymer. The polythiophene-based conductive polymer generally shows higher conductivity than that of the polyaniline-based conductive polymer, but affinity thereof to $H_2O$ is low as compared with that of the polyaniline-based conductive polymer, and even in the $H_2O$ dispersed material, once a film is formed, peeling thereof is difficult in a peeling and washing process by $H_2O$, or even if the film is peeled, it flows in a solid state such as a flake state and the like without being completely dissolved or dispersed again in $H_2O$. Therefore, there is a possibility of causing serious pattern defects on lithography.

Patent Document 3 discloses an antistatic film use technology for an electron beam lithography of a polythiophene-based conductive polymer, and shows an antistatic film function and good peelability to $H_2O$ of a complex of the polythiophene-based conductive polymer and a polyanion by the effect of adding a gemini type surfactant and the like. In addition, the composition described in Patent Document 3 uses a complex containing a polythiophene-based conductive polymer and a polyacid as a base polymer, so that there is a possibility that the acid derived from the polyacid exerts an effect on the resist film, similarly to the complex containing a polyaniline-based conductive polymer and a polyacid described in Patent Document 2, but by using a neutralizing agent such as an amine to alleviate the acidity, the above-described effect on lithography is minimized. However, as a result of adding a gemini type surfactant to provide functions of good coatability and peelability, and adding amines to alleviate the acidity, a side reaction by the amine on the resist film occurs to exert an effect on lithography, and in addition, the surface resistance (Ω/□) of the film to be an index of the antistatic property shows such a large value that sufficient antistatic property cannot be generated, and as a conclusion, a low resistivity inherently possessed by the polythiophene-based conductive polymer does not show as a function. Therefore, in the future, in the electron beam writing process which is required to have high antistatic property, there is a concern that it cannot correspond to sufficient divergence of charges.

From the above-described matters, it has been required to develop an antistatic film for electron beam resist writing that has good filterability, good film-formability of a flat film on an electron beam resist, has low resistivity and shows excellent antistatic property in an electron beam writing process, minimizes the effect of an acid diffused from the film on lithography, and has good peelability by $H_2O$ or an alkaline developer after writing.

The present invention has been made in view of the above-described circumstances, and an object thereof is to provide a conductive polymer composition that can form such an antistatic film for electron beam resist writing.

## SOLUTION TO PROBLEM

To achieve the object, the present invention provides a conductive polymer composition comprising:

(A) a polyaniline-based conductive polymer having at least one kind of a repeating unit represented by the following general formula (1); and

(B) a hydrogencarbonate including a cation represented by the following general formula (2-1) or (2-2),

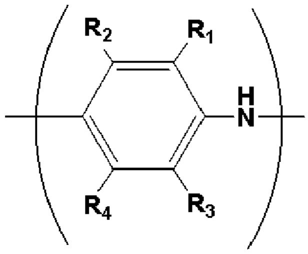

( 1 )

wherein $R_1$ to $R_4$ each independently represent a hydrogen atom, an acidic group, a hydroxy group, a nitro group, a halogen atom, a linear or branched alkyl group having 1 to 24 carbon atoms, a linear, branched, or cyclic hydrocarbon group having 1 to 24 carbon atoms containing a hetero atom, or a linear, branched, or cyclic hydrocarbon group having 1 to 24 carbon atoms partially substituted with a halogen atom,

$X^+$ (2-1)

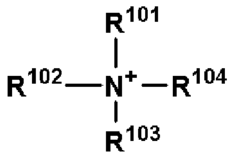

( 2-2 )

wherein X represents a monovalent alkali metal selected from lithium, sodium, potassium, and cesium, $R^{101}$, $R^{102}$, $R^{103}$, and $R^{104}$ each represent a hydrogen atom, a linear, branched, or cyclic alkyl group, alkenyl group, oxoalkyl group, or oxoalkenyl group having 1 to 12 carbon atoms, an aryl group having 6 to 20 carbon atoms, or an aralkyl group or aryloxoalkyl group having 7 to 12 carbon atoms, part or all of hydrogen atoms of these groups optionally being substituted with an alkoxy group or a hydroxy group and the groups optionally containing a hetero atom, $R^{101}$ and $R^{102}$, $R^{103}$ and $R^{104}$, and $R^{101}$, $R^{102}$, and $R^{104}$ optionally form a ring, and when a ring is formed, $R^{101}$ and $R^{102}$, $R^{103}$ and $R^{104}$, and $R^{101}$, $R^{102}$, and $R^{104}$ represent an alkylene group having 3 to 12 carbon atoms and optionally containing a hetero atom or represent a group including a heteroaromatic ring having the nitrogen atom in the formula in the ring, and $R^{101}$ and $R^{102}$ are optionally combined to form a group that is bonded with the nitrogen atom in the formula by a double bond, $R^{101}$ and $R^{102}$ optionally containing a hetero atom in this case.

A composition containing, as a component (B), a hydrogencarbonate including a cation represented by the general formula (2-1) or (2-2) can alleviate the acidity of a polyaniline-based conductive polymer (A) having at least one kind of a repeating unit represented by the general formula (1), and can control efficiently the diffusion of an acid to an adjacent layer.

Furthermore, the acidic group is preferably a sulfo group.

Such a component (A) makes it possible to achieve the advantageous effects of the present invention more sufficiently.

The component (B) is preferably contained in an amount of 1 part by mass to 150 parts by mass based on 100 parts by mass of the component (A).

When the contained amount of the component (B) is as described, acid diffusion from the conductive film formed with the conductive polymer composition to a touching adjacent layer can be further reduced.

The conductive polymer composition preferably further comprises (C) a nonionic surfactant.

When such a composition is employed, wettability of the conductive polymer composition to the body to be processed such as a substrate, etc., can be improved.

In this event, the component (C) is preferably contained in an amount of 0.1 parts by mass to 10 parts by mass based on 100 parts by mass of the component (A).

When the contained amount is as described, wettability to the surface of the body to be processed is better, and conductivity of the conductive film is also sufficient.

The conductive polymer composition preferably further comprises (D) a water-soluble polymer.

When such a composition is employed, it is possible to improve the uniformity of the film at the time of forming a film of the conductive polymer composition on the body to be processed such as a substrate.

In this event, the component (D) is preferably contained in an amount of 30 parts by mass to 150 parts by mass based on 100 parts by mass of the component (A).

When the component (D) is contained in such an amount, sufficient antistatic function can be achieved certainly while improving the uniformity of the film.

In addition, the present invention provides a coated product comprising a film of the above-described conductive polymer composition formed on a body to be processed.

The conductive film formed using the inventive conductive polymer composition is excellent in antistatic property, so that by covering various bodies to be processed with such an antistatic film, high-quality coated products having antistatic property can be obtained.

The body to be processed is preferably a substrate comprising a chemically-amplified resist film.

In this event, the body to be processed is preferably a substrate for obtaining a resist pattern by pattern irradiation using an electron beam.

Furthermore, the body to be processed is preferably a substrate comprising a chemically-amplified electron beam resist film having a sensitivity of 20 $\mu C/cm^2$ or more.

The inventive conductive polymer composition can be used suitably particularly in lithography using an electron beam or the like, and therefore, has high sensitivity and high resolution, and can achieve a resist pattern having few defects and having an excellent pattern profile.

In addition, the present invention provides a patterning process comprising the steps of:

forming an antistatic film on a resist film of a substrate provided with a chemically-amplified resist film by using the above-described conductive polymer composition;
performing pattern irradiation by using an electron beam; and
developing the substrate by using $H_2O$ or an alkaline developer to obtain a resist pattern.

According to such a patterning process, it is possible to prevent an electron beam distortion phenomenon derived from charging of a resist surface at the time of electron beam writing, and it is possible to obtain a resist pattern having high sensitivity, high resolution, few defects, and excellent pattern profile.

ADVANTAGEOUS EFFECTS OF INVENTION

Such a conductive polymer composition can be suitably used for an antistatic film showing charge dissipation with high efficiency in a charged state at the time of electron beam resist writing, and positional precision of the electron beam writing can be improved and enhanced.

The composition containing a component (A), containing a repeating unit represented by the general formula (1), and a component (B), shown as a hydrogencarbonate including a cation represented by the general formula (2-1) or (2-2), shows low resistivity after forming a film onto the substrate, good filterability, and good film-formability of a flat film on the electron beam resist. In addition, in the peeling process after film formation, peeling by $H_2O$ or an aqueous alkaline solution is facilitated. A composition containing such a component (A) and component (B) can form a conductive film having good film-formability and peelability by $H_2O$ or an aqueous alkaline solution and showing a surface resistivity (Ω/□) suitable for an antistatic film to give high positional accuracy in the electron beam writing to the resist, good resist pattern profile, and an antistatic film without peeling fragments or insoluble residual film to be resist pattern defects after resist development. In addition, the composition can be used suitably for electron beam lithography.

In addition, owing to the component (B), it is possible to control the effect of acid diffusion from the film formed from the composition to the adjacent layer, and it is possible to reduce pattern degradation caused by chemical factors from outside the resist layer in electron beam resist lithography.

The composition containing the component (A) and the component (B) of the present invention allows the following. In the electron beam writing to the electron beam resist and the patterning process, the formed film containing the composition can be peeled using $H_2O$ before heat treatment after writing, and it is possible to peel off the formed film by an aqueous alkaline solution (an alkaline developer) in the same manner as the elution portion of the resist pattern in the resist pattern development process after heat treatment after writing. Thus, peeling of the film by $H_2O$ or an aqueous alkaline solution is easy, so that the composition has an effect of reducing fine defects derived from a film formation material residue in the peeling process after electron beam writing.

The nonionic surfactant (C) and the water-soluble polymer (D) do not inhibit peelability by $H_2O$ or an aqueous alkaline solution after film formation in the inventive composition containing the component (A) and the component (B). The formed film using the composition containing the nonionic surfactant (C) and the water-soluble polymer (D) can also be easily peeled with $H_2O$ or an aqueous alkaline solution, and can be peeled with $H_2O$ before a heat treatment after electron beam writing. In addition, the film can also be peeled with an aqueous alkaline solution (alkaline developer) in the resist pattern development process in lithography after the heat treatment after the electron beam writing at the same

time as the elution portion of the resist pattern. A composition containing the components (C) and/or (D) in addition to the components (A) and (B) can also form a conductive film showing a surface resistivity (Ω/□) suitable for an antistatic film to give high positional accuracy in the electron beam writing to the resist, good resist pattern profile, and an antistatic film without peeling fragments or insoluble residual film to be resist pattern defects after resist development. In addition, the composition can be used suitably for electron beam lithography. Furthermore, since the film can be peeled off easily with $H_2O$ or an aqueous alkaline solution, the inventive composition also exhibits an effect of reducing ultrafine defects originating from a film formation residue in the peeling process after the electron beam writing.

In addition, by covering various bodies to be processed with an antistatic film formed by using the inventive conductive polymer composition, a coated product having high quality can be obtained.

DESCRIPTION OF EMBODIMENTS

As described above, there has been requirement for a conductive polymer composition which has good coatability and film-formability to a substrate and can form a conductive film with good film quality, is excellent in peelability by $H_2O$ or an aqueous alkaline solution, exhibits antistatic property with high charge dissipation ability, can control diffusion of the acid generated from the film to the adjacent layer, and is suitably used for a high conductivity antistatic film in resist lithography using an electron beam and the like.

Hereinafter, embodiments of the present invention will be described in detail, but the present invention is not limited thereto.

In a polyaniline compound showing high conductivity which uses the component (A) alone as a raw material, a sulfo group which is not consumed in doping is present so that a solution or a dispersion thereof shows acidity. When a liquid material using the component (A) alone as a raw material is formed as an antistatic film on an electron beam resist at the time of electron beam irradiation, an acid diffuses into the resist layer and exerts an adverse effect on the lithography. In addition, when a strong base such as a hydroxide is added as a neutralizing agent for the purpose of controlling diffusion of the acid, precise neutralization and reproduction are difficult, and moreover, when the composition is formed as an antistatic film on the electron beam resist at the time of electron beam irradiation, if an excessive strong base is present in the film, the strong base penetrates into the resist layer and causes a side reaction with a moiety such as an ester bond in a resist polymer, an acid generator, or an acid quencher, or reacts with an acid generated from an acid generator in the resist after writing, whereby the strong base exerts adverse effects on writing sensitivity and lithography after development.

The present inventors have earnestly studied the problems, and found out that by coating a resist with a composition containing a component (A) polyaniline-based conductive polymer which contains a repeating unit represented by the general formula (1) and a component (B) represented by a hydrogencarbonate which contains a cation represented by the general formula (2-1) or (2-2) at the time of electron beam irradiation to an electron beam resist, it is possible to form an antistatic film having good film-formability, film quality, and film flatness, showing suitable surface resistivity (Ω/□) for an antistatic film, having good peelability by $H_2O$ or an aqueous alkaline solution, and having controlled diffusion of an acid generated from the component (A) into the resist.

In addition, the following has been found. Allowing the conductive polymer dispersion to contain a nonionic surfactant (C) and/or a water-soluble polymer (D) further improves the wettability, to a surface of a body to be processed, of the composition containing the component (A), having the repeating unit represented by the general formula (1), and the hydrogencarbonate component (B), having the cation represented by the general formula (2-1) or (2-2). Thus, film homogeneity is improved, and an antistatic film having excellent film-formability and peelability is formed.

In addition, the conductive polymer composition to be suitably used for the above-described uses of the present invention can be obtained by, for example, mixing a polyaniline-based polymer of the component (A), a hydrogencarbonate of the component (B), and a solvent, and if necessary, a surfactant of the component (C) and a water-soluble polymer of the component (D), and filtering with a filter, etc. Furthermore, a coated product and a substrate provided with a thin film formed by using the inventive conductive polymer composition can be obtained by, for example, applying the inventive conductive polymer composition on a substrate and subjecting to heat treatment, IR or UV irradiation, etc.

Hereinafter, the present invention will be described in detail, but the present invention is not limited thereto.

<Conductive Polymer Composition>

The present invention is a conductive polymer composition containing:

(A) a polyaniline-based conductive polymer having at least one kind of a repeating unit represented by the general formula (1); and

(B) a hydrogencarbonate including a cation represented by the general formula (2-1) or (2-2).

[(A) Polyaniline-Based Conductive Polymer]

The polyaniline-based conductive polymer of the component (A) contained in the inventive conductive polymer composition is a polyaniline-based conductive polymer having at least one kind of a repeating unit represented by the following general formula (1).

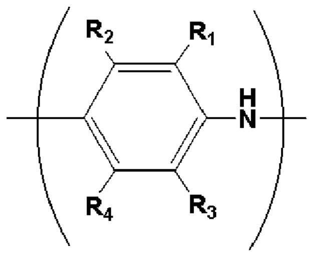

(1)

In the formula, $R_1$ to $R_4$ each independently represent a hydrogen atom, an acidic group, a hydroxy group, a nitro group, a halogen atom, a linear or branched alkyl group having 1 to 24 carbon atoms, a linear, branched, or cyclic hydrocarbon group having 1 to 24 carbon atoms containing a hetero atom, or a linear, branched, or cyclic hydrocarbon group having 1 to 24 carbon atoms partially substituted with a halogen atom.

The polyaniline-based conductive polymer is a $\pi$-conjugated system polymer, and is an organic polymer in which the main chain is constituted by aniline or a derivative other than a para-substituted material of aniline. In the present invention, the component (A) is preferably a polymer containing the repeating unit represented by the general formula (1) (aniline monomer), at least one of $R_1$ to $R_4$ being a sulfo group. Incidentally, the sulfo group is included in acidic groups. Alternatively, the component (A) may be a polymer that does not have a sulfo group in the structure of the polymer, and exhibits a conductive function by being doped with a dopant such as an acid or a halogen ion outside the molecule. However, from the viewpoints of high affinity to $H_2O$, high-efficiency filterability, peelability to $H_2O$ or an alkali developer after film formation, low-defect property in lithography, easiness in polymerization, low reaggregation during storage, and stability in the air, a polymer particularly effective as the component (A) is a self-doping type, i.e., intramolecular-doping type polyaniline-based conductive polymer having at least one kind of repeating unit represented by the general formula (1).

The self-doping type polyaniline-based conductive polymer preferably contains an aniline in which at least one of $R_1$ to $R_4$ in the repeating unit represented by the general formula (1) is substituted with a sulfo group, and in order to reinforce the $H_2O$ affinity of such a polyaniline-based conductive polymer further, a hydrophilic substituent can also be introduced besides the sulfo group in $R_1$ to $R_4$. As the hydrophilic substituent, a functional group, such as an alkoxy group, a carboxy group, or a hydroxy group, can be introduced.

Typical examples of sulfonic acid-substituted aniline include aminobenzenesulfonic acid derivatives. Examples of aminobenzenesulfonic acid derivatives include o- and m-aminobenzenesulfonic acid, aniline 2-6-disulfonic acid, and aniline 3-5-disulfonic acid. Other examples of anilines having a sulfo group include: alkyl group-substituted benzenesulfonic acids, such as methylaminobenzenesulfonic acid, ethylaminobenzene-sulfonic acid, n-propylaminobenzenesulfonic acid, iso-propylaminobenzenesulfonic acid, n-butylaminobenzenesulfonic acid, sec-butylaminobenzenesulfonic acid, and t-butylaminobenzenesulfonic acid; alkoxyaminobenzenesulfonic acids, such as methoxyaminobenzenesulfonic acid, ethoxyaminobenzenesulfonic acid, and propoxyaminobenzenesulfonic acid; hydroxy-substituted aminobenzenesulfonic acids; nitro group-substituted aminobenzenesulfonic acids; halogen group-substituted aminobenzenesulfonic acids, such as fluoro-aminobenzenesulfonic acid, chlorobenzenesulfonic acid, and bromobenzenesulfonic acid; etc. In particular, alkoxyaminobenzenesulfonic acids and hydroxy-substituted aminobenzenesulfonic acids are used suitably from the viewpoints of the $H_2O$ affinity, conductivity, reactivity, thermal stability of the product of the intramolecular-doping type polyaniline-based conductive polymer. In addition, one of these aminobenzenesulfonic acids may be used, or two or more kinds may be used in mixture at any proportion. Furthermore, anilines in which none of the $R_1$ to $R_4$ in the repeating unit represented by the general formula (1) is substituted with a sulfo group may be copolymerized.

The polyaniline-based conductive polymer of the component (A) can also be formed by copolymerizing an aniline in which at least one of the $R_1$ to $R_4$ in the repeating unit represented by the general formula (1) is substituted with a sulfo group and an aniline that does not have a single sulfo group. In such a case, the affinity to $H_2O$ is reduced in some cases due to the reduction in the proportion of sulfo groups present in the produced polymer, and to compensate for the reduction, it is desirable to introduce a hydrophilic substituent to the aniline that does not have a single sulfo group, or introduce a hydrophilic substituent to the aniline that has a sulfo group. It is desirable for the hydrophilic substituent to be a functional group such as an alkoxy group, a carboxy group, or a hydroxy group.

Specific examples of aniline monomers desirable when copolymerizing with an aniline having no sulfo groups

in $R_1$ to $R_4$ as a repeating unit include aniline, 2-methoxyaniline, 2-isopropoxyaniline, 3-methoxyaniline, 2-ethoxyaniline, 3-ethoxyaniline, 3-isopropoxyaniline, 3-hydroxyaniline, 2,5-dimethoxyaniline, 2,6-dimethoxyaniline, 3,5-dimethoxyaniline, 2,5-diethoxyaniline, 2-methoxy-5-methylaniline, 5-tertbutyl-2-methoxyaniline, 2-hydroxyaniline, 3-hydroxyaniline, etc.

In particular, aniline, 2-methoxyaniline, 3-methoxyaniline, 2-ethoxyaniline, 3-ethoxyaniline, 2-isopropoxyaniline, 3-isopropoxyaniline, and 3-hydroxyaniline are suitably used from the viewpoints of hydrophilicity, conductivity, reactivity, and thermal stability of the product even when copolymerized with an aniline monomer in which at least one of the $R_1$ to $R_4$ in the general formula (1) is a sulfo group.

[(B) Hydrogencarbonate]

The component (B) contained in the inventive conductive polymer composition is a hydrogencarbonate including a cation represented by the following general formula (2-1) or (2-2).

$X^+$ (2-1)

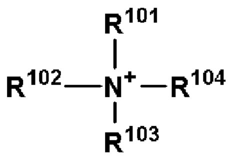

( 2-2 )

In the formula, X represents a monovalent alkali metal selected from lithium, sodium, potassium, and cesium. $R^{101}$, $R^{102}$, $R^{103}$, and $R^{104}$ each represent a hydrogen atom, a linear, branched, or cyclic alkyl group, alkenyl group, oxoalkyl group, or oxoalkenyl group having 1 to 12 carbon atoms, an aryl group having 6 to 20 carbon atoms, or an aralkyl group or aryloxoalkyl group having 7 to 12 carbon atoms, part or all of hydrogen atoms of these groups optionally being substituted with an alkoxy group or a hydroxy group and the groups optionally containing a hetero atom. $R^{101}$ and $R^{102}$, $R^{103}$ and $R^{104}$, and $R^{101}$, $R^{102}$, and $R^{104}$ optionally form a ring, and when a ring is formed, $R^{101}$ and $R^{102}$, $R^{103}$ and $R^{104}$, and $R^{101}$, $R^{102}$, and $R^{104}$ represent an alkylene group having 3 to 12 carbon atoms and optionally containing a hetero atom or represent a group including a heteroaromatic ring having the nitrogen atom in the formula in the ring. $R^{101}$ and $R^{102}$ are optionally combined to form a group that is bonded with the nitrogen atom in the formula by a double bond, $R^{101}$ and $R^{102}$ optionally containing a hetero atom in this case.

The inventive conductive polymer composition alleviates the acidity of the composition, not by neutralization using a strong base as in conventional techniques, but by the component (B) hydrogencarbonate having an ion exchange effect on a sulfo group contained in the component (A), for example. Thus, the diffusion of an acid to an adjacent layer can be controlled efficiently. In particular, the acidity of the composition can be alleviated to be near neutral. In addition, the component (B) hydrogencarbonate in the present invention has less influence by a chemical reaction to constituents of the resist before writing than strongly basic substances. Therefore, the inventive conductive polymer composition can be used suitably for an antistatic film in electron beam lithography.

As the component (B), a material with high solubility in water is preferable in view of handleability. Furthermore, in view of resistivity when a composition is formed with the component (A) polyaniline-based conductive polymer and dispersibility in the composition and in a film after film formation, the cation represented by (2-2) preferably has a molecular weight of 300 or less.

Hydrogencarbonates that contain the cation represented by the general formula (2-1) include lithium hydrogencarbonate, sodium hydrogencarbonate, potassium hydrogencarbonate, and cesium hydrogencarbonate.

Typical cations represented by the general formula (2-2) are shown below.

$NH_4^+$ 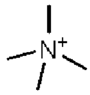 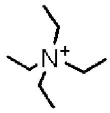 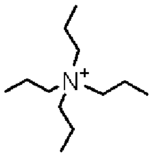 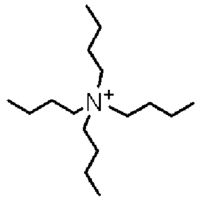 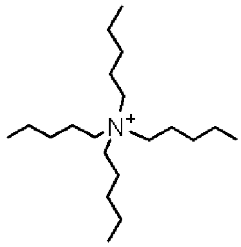

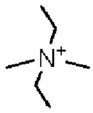 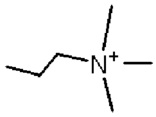 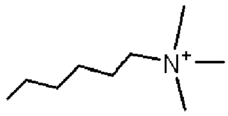 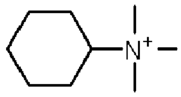

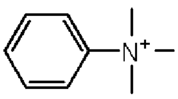 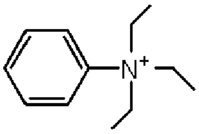 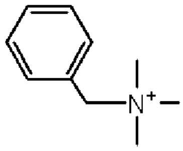 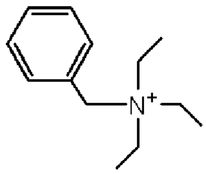 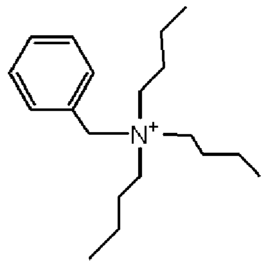

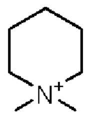 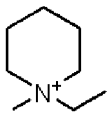 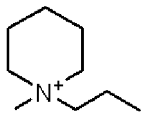 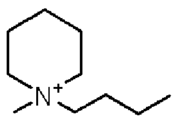 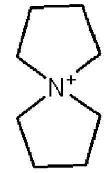 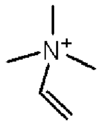 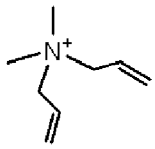

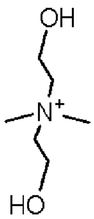 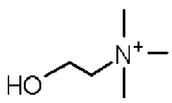 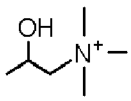 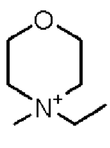 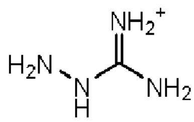

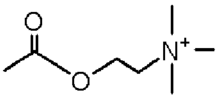 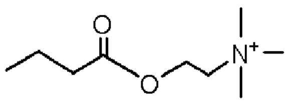 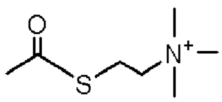 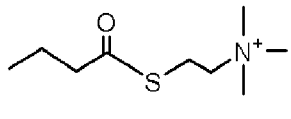

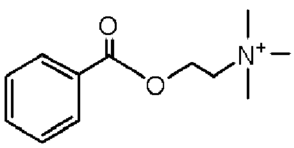 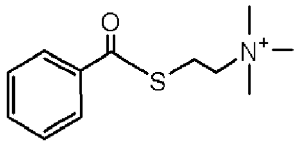

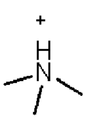 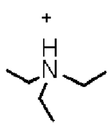 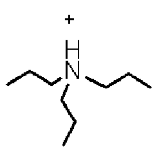 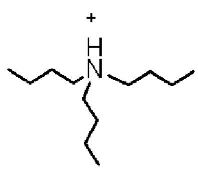

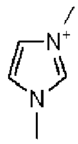 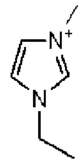 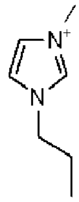 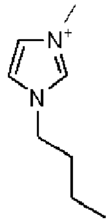 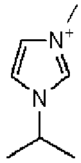 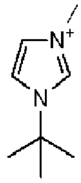

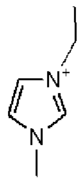 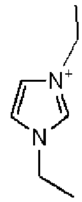 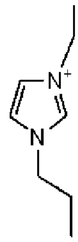 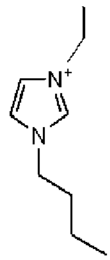 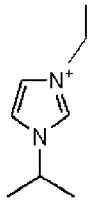 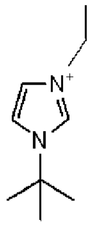

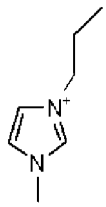 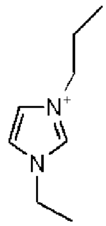 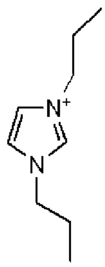 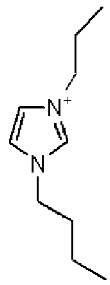 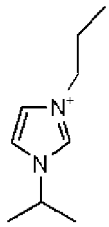 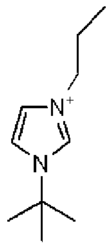

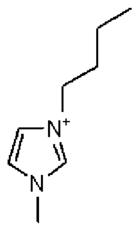 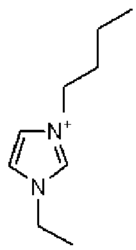 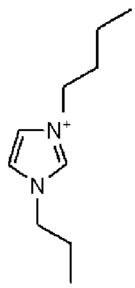 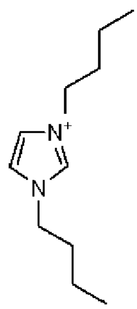 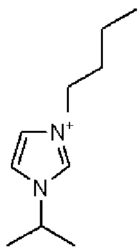 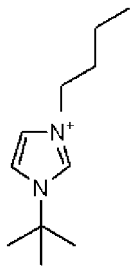

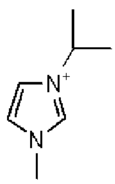 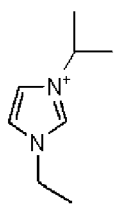 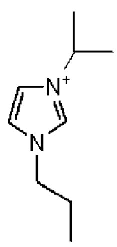 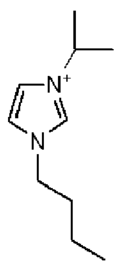 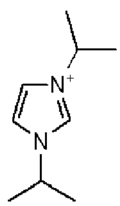 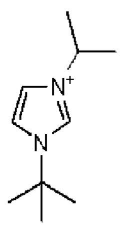

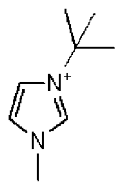 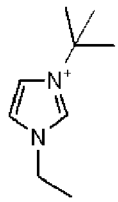 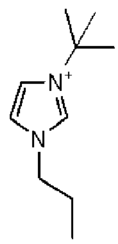 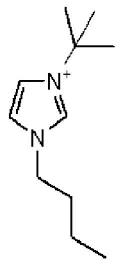 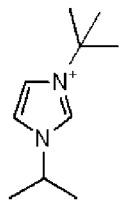 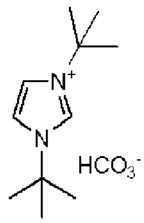

[Other Components]

(Surfactant)

In the present invention, in order to increase wettability to the body to be processed such as a substrate, a surfactant may be contained. Examples of such surfactants include various kinds of surfactants such as nonionic, cationic, and anionic surfactants, and from stability of the conductive polymer, a nonionic surfactant (C) is particularly preferable. Specifically, for example, nonionic surfactants such as a polyoxyethylene alkyl ether, a polyoxyethylene alkylphenyl ether, a polyoxyethylene carboxylic acid ester, a sorbitan ester, a polyoxyethylene sorbitan ester, etc., are suitable, and there may be mentioned cationic surfactants, such as an alkyltrimethylammonium chloride, an alkylbenzylammonium chloride, etc., anionic surfactants, such as an alkyl or alkylallyl sulfate, an alkyl or alkylallyl sulfonate, a dialkyl sulfosuccinate, etc., and amphoteric surfactants such as an amino acid type, a betaine type, etc.

When such a material is employed, wettability of the conductive polymer composition to the body to be processed such as a substrate can be increased.

(Water-Soluble Polymer)

In addition, in the present invention, in order to improve uniformity of the film when the film is formed onto the body to be processed such as a substrate, a water-soluble polymer (D) may be further contained. Such a water-soluble polymer is preferably a homopolymer or a copolymer having hydrophilic repeating units. In addition, such a hydrophilic repeating unit preferably has a vinyl group as a polymerizable functional group, and furthermore, in view of controlling diffusion of an acid generated from the component (A), a compound containing a nitrogen atom in the molecule is preferable. At this time, if the nitrogen atom in the molecule does not have nucleophilicity, it is more preferable since there is no risk of causing a side reaction to a functional group to be nucleophilically attacked such as an ester group contained in the resist polymer or the acid generator in the resist composition as described above. Therefore, as the above-described repeating unit, a nitrogen-containing heterocyclic compound is more desirable than material having a nitrogen atom at the terminal like acrylamides. In addition, at that time, a material in which the nitrogen atom forms the main chain of the cyclic structure and is bonded to the vinyl group is more preferable. Examples of such a repeating unit include N-vinyl-2-pyrrolidone, N-vinylcaprolactam, etc.

When such a material is employed, it is possible to improve uniformity of the film when the conductive polymer composition is applied onto a body to be processed such as a substrate to form a film.

<Method for Manufacturing Polyaniline-Based Conductive Polymer>

Patent Document 4 (JP 3631910 B2) proposes a self-doping type sulfonated polyaniline which exhibits conductivity without forming a complex with a doping agent or a polymer dopant and a method for synthesizing the polyaniline. Many of the polyaniline materials before these are materials to which a dopant is added, but are insoluble in almost all the organic solvents, and the material has basically low solubility even when the solvent is $H_2O$, and even if it is possible to disperse the polyaniline in $H_2O$ using a polymer dopant, the polyaniline has particle property so that it is difficult to remove aggregates of particles which can be a cause of particle defects in uses such as thin film formation in relation with semiconductors and a light-transmission film for electronic devices, and in addition, in filtration purification to be usually used for purification of a polymer, there has been a limit to purification. For example, aggregates are filtered out and such like by a filtration filter to cause fluctuation of the solid content, and furthermore, there has been a limit to reduce the pore size of the filtration filter and the like depending on particle size, even in the case of mono-size particles.

When the component (A) handled in the present invention is a self-doping type polyaniline, for example, the polyaniline can be obtained by allowing an aniline monomer to react with an oxidizing agent in an aqueous solution or a mixed solution of water and an organic solvent to perform oxidation polymerization. As the polymerization recipe of the component (A), a well-known method can be applied and is not particularly limited. Specifically, a monomer for

obtaining a repeating unit represented by the general formula (1) can be polymerized by oxidation polymerization, and also other synthesis methods such as an electrolytic oxidation method. As such a method, for example, the prescriptions described in JP 3154460 B2 and JP 2959968 B2 can be applied.

As the polymerization initiator to be used for oxidation polymerization of the component (A), it is possible to use peroxodisulfate salts (persulfate salt), such as ammonium peroxodisulfate (ammonium persulfate), sodium peroxodisulfate (sodium persulfate), potassium peroxodisulfate (potassium persulfate), etc., peroxides, such as hydrogen peroxide, ozone, etc., organic peroxides, such as benzoyl peroxide, etc., oxygen, etc.

As the reaction solvent to be used for carrying out oxidation polymerization, water or a mixed solvent of water and a solvent can be used. The solvent herein used is preferably a solvent which is miscible with water and capable of dissolving or dispersing the components (A) and (B). Examples include alcohols, such as methanol, ethanol, propanol, butanol, etc., polyhydric aliphatic alcohols, such as ethylene glycol, propylene glycol, 1,3-propanediol, dipropylene glycol, 1,3-butylene glycol, 1,4-butylene glycol, D-glucose, D-glucitol, isoprene glycol, 1,2-butanediol, 1,3-butanediol, 1,4-butanediol, 2,3-butanediol, 1,2-pentanediol, 1,5-pentanediol, 1,2-hexanediol, 1,6-hexanediol, 1,9-nonanediol, neopentyl glycol, etc., linear ethers, such as dialkyl ether, ethylene glycol monoalkyl ether, ethylene glycol dialkyl ether, propylene glycol monoalkyl ether, propylene glycol dialkyl ether, polyethylene glycol dialkyl ether, polypropylene glycol dialkyl ether, etc., cyclic ether compounds, such as dioxane, tetrahydrofuran, etc., polar solvents, such as cyclohexanone, methyl amyl ketone, ethyl acetate, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, N-methyl-2-pyrrolidone, N,N'-dimethylformamide, N,N'-dimethylacetamide, dimethylsulfoxide, hexamethylene phosphoric triamide, etc., carbonate compounds, such as ethylene carbonate, propylene carbonate, etc., heterocyclic compounds, such as 3-methyl-2-oxazolidinone, etc., and nitrile compounds such as acetonitrile, glutaronitrile, methoxyacetonitrile, propionitrile, benzonitrile, etc. One of these solvents may be used, or a mixture of two or more kinds thereof may be used. A contained amount of these solvents miscible with water is preferably 50 mass% or less based on the whole reaction solvent.

Polymerization of the component (A) polyaniline-based conductive polymer can be carried out by dissolving the repeating unit represented by the general formula (1) as a monomer in a solvent and allowing the monomer to react with a polymerization initiator. However, when the solubility of the monomer as a simple substance is low, an initial concentration may be low in some cases. The lowering in the initial concentration causes lowering in polymerization reaction, and the polymer to be formed cannot have a molecular weight for possessing sufficient conductivity or film-formability in some cases. Therefore, in order to increase sufficiently the initial concentration of the monomer at the time of polymerization, it is desirable to add a base to the monomer to form a salt with a sulfo group in the monomer to increase solubility thereof, and then to perform polymerization.

The initial concentration of the monomer for obtaining the repeating unit of the general formula (1) in the polymerization is preferably 0.5 to 2.0 mol/L, further preferably 1.0 to 1.5 mol/L.

The repeating unit represented by the general formula (1) is more preferably subjected to oxidation polymerization by an oxidizing agent in the presence of a base. The sulfo group in the monomer for obtaining a repeating unit of the general formula (1) in the polymerization forms a salt with the base.

In addition, when the above-described polymerization is carried out, in an aqueous solution or a mixed solution of water and an organic solvent, a co-presented base forms a salt with an acidic group of the component (A) as an organic cation represented by the following general formula (4) or an ion of an alkali metal or an alkaline earth metal.

The organic cation represented by the following general formula (4) is preferably ammonia, aliphatic amines, cyclic saturated amines, and cyclic unsaturated amines.

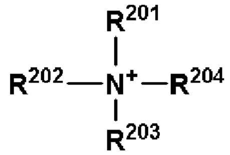

(4)

In the formula, $R^{201}$, $R^{202}$, $R^{203}$ and $R^{204}$ each independently represents a hydrogen atom, a linear, branched or cyclic alkyl group, alkenyl group, oxoalkyl group or oxoalkenyl group each having 1 to 12 carbon atoms, an aryl group having 6 to 20 carbon atoms, or an aralkyl group or an aryloxoalkyl group each having 7 to 12 carbon atoms, and a part or whole of the hydrogen atoms of these groups may be substituted by an alkoxy group. $R^{201}$ and $R^{202}$, or $R^{201}$, $R^{202}$ and $R^{204}$ may form a ring, and when a ring is formed, $R^{201}$ and $R^{202}$, and $R^{201}$, $R^{202}$ and $R^{204}$ each represent an alkylene group having 3 to 10 carbon atoms or a heteroaromatic ring having the nitrogen atom in the formula in the ring.

The component (A) polyaniline-based conductive polymer thus polymerized is filtered and isolated as precipitated material from the reaction mixture. As the filtration method, reduced pressure filtration, pressure filtration, centrifugation, centrifugal filtration and the like are used, and from easiness in the method and adaptability to large-scale synthesis, filtration under reduced pressure is suitable and the filtrated precipitates can be washed with a poor solvent on a funnel.

In addition, the component (A) polyaniline-based conductive polymer thus obtained is dissolved again in $H_2O$ after drying, and impurities can be removed by the method of ultrafiltration and the like.

Examples of the system of the ultrafiltration include a pressurization system, a cross-flow system, etc., and from the viewpoints of productivity and a scale of the purified material, it is preferable to use a cross-flow system. In addition, even in the cross-flow system, depending on a prescription, there are a continuous circulation system (purification is controlled by time, and in a purification process, a stock solution is diluted by adding a solvent as needed to deal with viscosity increased by concentration) and a sequential processing system (for purifying a stock solution, a process in which at the time of concentrating to a concentration of 2-fold, the stock solution is diluted to the original concentration is regarded as one process, and the process is repeated until the desired degree of purification is achieved), and the component (A) can be processed by either of the prescriptions.

In addition, examples of the structure of the membrane to be used for ultrafiltration include a flat membrane type, a hollow fiber membrane type, a tubular membrane type, a spiral membrane type, etc., and examples of a material of the separating membrane include cellulose, cellulose acetate, polysulfone, polypropylene, polyester, polyethersulfone, polyvinylidene fluoride and the like, and in the present process, there is no limitation in any combination, and in the case that the solvent of the purified material is $H_2O$ or an acidic solution, a separation membrane made of polyethersulfone is desirable, and as the structure of the membrane, it is preferable to use a hollow fiber membrane type in view of a scale of the treating liquid and treatment efficiency.

Considering that the substances to be removed in the ultrafiltration process are a small molecule of an unreacted substance and a polymerization by-product, a fractionation molecular weight of the membrane is preferably in the range of 1,000 to 150,000, and further preferably in the range of 5,000 to 30,000. Incidentally, in the present invention, the molecular weight of the polymer can be, for example, a weight-average molecular weight (Mw) and a number-average molecular weight (Mn) measured by gel permeation chromatography (GPC) in terms of polystyrene, using tetrahydrofuran as an eluent.

In addition, at this time, considering concentration of the purified stock solution to a 2-fold concentration and efficiency of dialysis by a filtration membrane, a concentration of the stock solution is preferably 0.5 to 1.5% by weight.

In the system of the ultrafiltration, when purification is carried out by a cross-flow sequential processing system, impurity ions in the filtrate can be quantified by ion chromatography at each stage. Here, in the ions which can be quantified by analysis, there are $SO_4^{2-}$, $NH_4^+$, $Na^+$ and the like, and other ions can also be appropriately made an object to be quantified. The concentrations of $SO_4^{2-}$, $NH_4^+$ and $Na^+$ at the time of completion of ultrafiltration purification are preferably 10 ppm or less, and more preferably 1 ppm or less.

The component (A) polyaniline-based conductive polymer purified by ultrafiltration is a solution of $H_2O$ at the time of completion of the purification, and can be precipitated and purified again with a water-soluble poor solvent such as acetone and the like. The precipitated component (A) polyaniline-based conductive polymer is filtered under reduced pressure and can be washed again with a poor solvent.

<Method for Manufacturing Conductive Polymer Composition>

The conductive polymer composition suitably used for the above-described uses of the present invention can be obtained by, for example, mixing the polyaniline-based polymer of the component (A), the hydrogencarbonate of the component (B) and a solvent, and further, if necessary, the nonionic surfactant of the component (C) and the water-soluble polymer of the component (D), and filtering through a filter or the like.

In this event, when the component (A) polyaniline-based conductive polymer and the component (B) hydrogencarbonate in the present invention, and furthermore, the component (C) nonionic surfactant and the component (D) water-soluble polymer are all to be dissolved, the solvent of the composition containing the component (A) preferably contains $H_2O$ as a main solvent, considering delamination of an electron beam resist on a substrate on which the resist is formed and degradation in lithography performance due to mixing.

A solid content of the component (A) in the composition may vary depending on the charge diffusion property and film thickness required for the antistatic film of the electron beam resist, but considering peeling immediately after electron beam writing or peelability with high efficiency at development, the solid content is preferably 0.05 to 1.0 wt%, further preferably 0.08 to 0.5 wt%.

Meanwhile, in this event, the component (B) is preferably contained in an amount of 1 part by mass to 150 parts by mass based on 100 parts by mass of the component (A). Furthermore, the component (B) is preferably contained in an amount of 10 parts by mass to 120 parts by mass, further preferably 20 parts by mass to 100 parts by mass based on 100 parts by mass of the component (A).

When the contained amounts of the component (A) and the component (B) are as described above, acid diffusion from the conductive film formed with the conductive polymer composition to the contacting adjacent layers can be more reduced. When a body to be processed on which such a conductive film is to be formed is a substrate provided with a chemically-amplified resist film and the object thereof is to obtain an antistatic effect at the time of electron beam writing, the conductive film exhibits the antistatic effect and enhances the precision of the writing position, and the effect of acid diffusion from the conductive film to the resist is reduced so that a high-resolution resist pattern can be obtained.

In addition, when a nonionic surfactant (C) is to be added, the contained amount thereof is preferably 0.1 parts by mass to 10 parts by mass based on 100 parts by mass of the component (A), and moreover, the amount is more preferably 0.5 parts by mass to 3 parts by mass.

Furthermore, when a water-soluble polymer (D) is to be added, the contained amount thereof is preferably 30 parts by mass to 150 parts by mass based on 100 parts by mass of the component (A), and moreover, the amount is more preferably 90 parts by mass to 120 parts by mass.

When the conductive polymer composition described above is employed, the composition has good filterability and coatability, and an antistatic film suitable for electron beam lithography can be formed.

The conductive polymer composition thus obtained can form an antistatic film by being applied onto an electron beam resist or a body to be processed such as a substrate by various methods. Specific examples include application with a spin coater and the like, bar coater, dipping, comma coating, spray coating, roll coating, screen printing, flexographic printing, gravure printing, inkjet printing and the like. After coating, a conductive film can be formed by performing heat treatment using a hot air circulation furnace, a hot plate, etc., IR or UV irradiation, etc.

Furthermore, the inventive conductive polymer composition can be suitably used not only for an antistatic film relating to lithography, but also as a material for forming a laminated film as a device constitutional element in an organic thin film device. Moreover, the inventive conductive polymer composition can also be suitably used as a material for forming an electrode film such as a transparent electrode use for an organic EL display, an organic EL lighting, a solar cell, and the like from excellent conductivity, film-formability, and transparency, or a material for forming a carrier transfer film similarly including a carrier injection layer or carrier transfer layer uses for an organic EL display, an organic EL lighting, a solar cell and the like from the properties exhibiting carrier transfer with high efficiency derived from a $\pi$-conjugated system network.

When the component (B) is used in the inventive conductive polymer composition, even when used as a formation layer in a multilayer structure in the constitution of an organic thin film device, the component (B) does not exert any adverse effects by an acid on an adjacent layer in the laminated structure, so that it is possible to avoid degeneration at the interface of the constitutional materials of the adjacent layer or side reactions and degradation by an acid after the device is constituted.

<Coated Product>

The present invention provides a coated product including the inventive conductive polymer composition being formed as a film on a body to be processed. The conductive film formed using the inventive conductive polymer composition is excellent in antistatic property, so that by covering various bodies to be processed with such an antistatic film, a coated product with high quality can be obtained.

Examples of the body to be processed include a glass substrate, a quartz substrate, a photomask blank substrate, a mask blank substrate coated with a photoresist, a resin substrate, a silicon wafer, a compound semiconductor wafer, such as a gallium arsenide wafer, an indium phosphide wafer and the like, and flexible substrates such as a resin film, ultra-thin film glass, a metal foil and the like, and furthermore, the surface layer of these substrates may be coated with an organic or inorganic thin film layer for the purpose of planarization, insulation, and prevention of gas and moisture transmission.

As a coated product which is covered with the conductive film obtained by using the inventive conductive polymer composition, examples include a glass substrate, a resin film, a substrate coated with a photoresist, etc., coated with the inventive conductive polymer composition.

In addition, since the inventive conductive polymer composition can be delaminated easily with $H_2O$ or an alkaline developer adopted in photoresist development or the like after film formation, the composition can be used suitably on a substrate having a body to be processed provided with a chemically-amplified resist film. Furthermore, when the substrate is for obtaining a resist pattern by irradiation with an electron beam, favorable lithography results can be achieved by the antistatic property of the inventive conductive polymer composition. In addition, the body to be processed may be a substrate provided with a chemically-amplified electron beam resist film having a sensitivity of 20 $\mu C/cm^2$ or more.

<Patterning Process>

Furthermore, the present invention provides
a patterning process including the steps of:

forming an antistatic film on a resist film of a substrate provided with a chemically-amplified resist film by using the inventive conductive polymer composition;
performing pattern irradiation by using an electron beam; and
developing the substrate by using $H_2O$ or an alkaline developer to obtain a resist pattern.

The patterning process can be carried out according to a conventional manner except for using the inventive conductive polymer composition, and the antistatic film formed using the conductive polymer composition may be, after electron beam writing, peeled off by $H_2O$ before a heat treatment, or may be peeled off using a developer in the resist pattern development step after a heat treatment. After development of the resist pattern, an etching process and other various kinds of processes may be of course carried out.

According to such a patterning process, charging phenomenon at the time of the electron beam writing can be prevented, and a pattern having high resolution and also a good pattern profile can be obtained.

EXAMPLE

Hereinafter, the present invention will be described more specifically with reference to Production Examples, Examples, and Comparative Examples. However, the present invention is not limited thereto.

[Synthesis of Self-Doping Type Polyaniline-Based Conductive Polymer]

In the component (A) polyaniline-based conductive polymer used in the present invention, methoxyaminobenzenesulfonic acids, in particular, polymerization of 3-amino-4-methoxybenzenesulfonic acid is particularly preferable among the above-described repeating units in view of $H_2O$ solubility, conductivity, and cost of raw materials. Furthermore, in order to increase functions as an antistatic film, copolymerization with an unsubstituted aniline is more preferable. The coexisting base at the time of polymerization is preferably pyridine in view of handling, cost, basicity and harmlessness to the constitutional elements of the resist.

(Production Example) Synthesis of Polyaniline-Based Conductive Polymer

In 400 ml of acetonitrile/$H_2O$ mixed liquid (acetonitrile/$H_2O$ = 1/1) was dissolved 79.9 g of ammonium peroxodisulfate, and to the mixture in a cooled state at 0°C was added dropwise, at a dropping rate of 1.3 ml/min, a liquid in which 67.4 g of 3-amino-4-methoxybenzenesulfonic acid and 3.3 g of purified aniline were completely dissolved in 300 ml of an acetonitrile/$H_2O$ mixed liquid (acetonitrile/$H_2O$ = 1/1) containing 1.4 mol/L of pyridine and cooled to 0°C. After the entire solution had been dropped, the temperature of the reaction system was raised to 25°C and the reaction system was stirred for 12 hours. After stirring, the precipitated material was collected with a Buchner funnel, washed with methanol, and then dried to obtain 45 g of a powder-form conductive polymer. The conductive polymer thus obtained was dissolved again in $H_2O$ so as to achieve a concentration of 1.0 wt% and purification was carried out by ultrafiltration (hollow fiber type, MWCO = 10000) until the $NH_4^+$ and $SO_4^{2-}$ ion concentrations in the dialysate was less than 1.0 ppm. The ultrafiltration conditions were as follows.

Fractionation molecular weight of ultrafiltration membrane: 10 K
Cross flow system
Flow rate of supply liquid: 3,000 mL/min
Membrane partial pressure: 0.15 Pa

After concentration, the purified liquid was added dropwise to 4,000 mL of acetone to obtain a powder. This powder was again dispersed in 2,000 mL of ultrapure water, and after concentration with a rotary evaporator, was again added dropwise into 4,000 mL of acetone to recrystallize the powder. Then, the powder was dried to obtain a brown conductive polymer.

Ultrafiltration can be executed in either of the prescriptions, in a cross-flow system, of a continuous circulation system (purification is controlled by time, and in a purification process, a stock solution is diluted by adding a solvent as needed to deal with high viscosity by concentration) and a sequential processing system (for purifying a stock solution, a process in which the stock solution is diluted to the original concentration at the time of concentrating to a concentration

of 2-fold is regarded as one process, and the process is repeated until the desired degree of purification is achieved), and a sequential processing system is preferably used to observe the transition of removal of impurity ions in the purification process. In the purification by the sequential processing system, the results of performing quantitative analysis of the concentrations of impurity ions contained in the discharged dialysate by ion chromatography are shown in Table 1.

[Table 1]

| | | | [ ppm ] |
|---|---|---|---|
| Samples | $SO_4^{2-}$ | $Na^+$ | $NH_4^+$ |
| 1st process | 110 | <0.1 | 35 |
| 2nd process | 39 | <0.1 | 14 |
| 3rd process | 7.0 | <0.1 | 3.7 |
| 4th process | 2.1 | <0.1 | 1.7 |
| 5th process | 0.9 | <0.1 | 1.2 |
| 6th process | 0.4 | <0.1 | 0.9 |
| 7th process | 0.4 | <0.1 | 0.8 |
| 8th process | 0.3 | <0.1 | 0.7 |
| 9th process | 0.3 | <0.1 | 0.6 |
| 10th process | 0.3 | <0.1 | 0.6 |
| 11th process | 0.3 | <0.1 | 0.5 |
| 12th process | 0.2 | <0.1 | 0.4 |
| 13th process | 0.2 | <0.1 | 0.2 |

[Preparation of Conductive Polymer Composition Containing Polyaniline-Based Conductive Polymer]

(Example 1)

In ultrapure water in which 0.134 g of tetraethylammonium hydrogencarbonate had been dissolved, 0.300 g of the brown powder of the polyaniline-based conductive polymer obtained in the Production Example was dissolved. After stirring the mixture at room temperature for 2 hours, the mixture was filtered through a polyethylene filter subjected to a hydrophilization treatment, and the resultant was obtained as Example 1.

(Example 2)

Except that the tetraethylammonium

hydrogencarbonate of Example 1 was changed to 0.212 g of tetra n-butyl ammonium hydrogencarbonate, preparation was carried out in the same manner as in Example 1 to obtain a conductive polymer composition.

(Example 3)

Except that the tetraethylammonium

hydrogencarbonate of Example 1 was changed to 0.114 g of triethylammonium hydrogencarbonate, preparation was carried out in the same manner as in Example 1 to obtain a conductive polymer composition.

(Example 4)

Except that the tetraethylammonium

hydrogencarbonate of Example 1 was changed to 0.121 g of 1-ethyl-3-methylimidazolium, preparation was carried out in the same manner as in Example 1 to obtain a

conductive polymer composition.

(Example 5)

Except that the tetraethylammonium

hydrogencarbonate of Example 1 was changed to 0.130 g of 1-ethyl-3-n-butylimidazolium, preparation was carried out in the same manner as in Example 1 to obtain a conductive polymer composition.

(Example 6)

Except that the tetraethylammonium

hydrogencarbonate of Example 1 was changed to 0.150 g of 1,3-diisopropylimidazolium, preparation was carried out in the same manner as in Example 1 to obtain a conductive polymer composition.

(Example 7)

Except that the tetraethylammonium

hydrogencarbonate of Example 1 was changed to 0.170 g of 1,3-di-tert-butylimidazolium, preparation was carried out in the same manner as in Example 1 to obtain a conductive polymer composition.

(Example 8)

In ultrapure water in which 0.134 g of tetraethylammonium hydrogencarbonate had been dissolved, 0.00450 g of acetylene glycol-based surfactant SURFYNOL 465 (available from Nissin Chemical Industry Co., Ltd.) was dissolved as a nonionic surfactant and 0.330 g of polyvinyl pyrrolidone (available from NACALAI TESQUE, INC.) was dissolved as a water-soluble polymer compound. Furthermore, 0.300 g of the brown powder of the polyaniline-based conductive polymer obtained in the Production Example was dissolved therein. After stirring the mixture at room temperature for 2 hours, the mixture was filtered through a polyethylene filter subjected to hydrophilization treatment, and the resultant was obtained as Example 8.

(Example 9)

Except that the tetraethylammonium

hydrogencarbonate of Example 8 was changed to 0.212 g of tetra n-butyl ammonium hydrogencarbonate, preparation was carried out in the same manner as in Example 8 to obtain a conductive polymer composition.

(Example 10)

Except that the tetraethylammonium

hydrogencarbonate of Example 8 was changed to 0.114 g of triethylammonium hydrogencarbonate, preparation was carried out in the same manner as in Example 8 to obtain a conductive polymer composition.

(Example 11)

Except that the tetraethylammonium

hydrogencarbonate of Example 8 was changed to 0.121 g of 1-ethyl-3-methylimidazolium, preparation was

carried out in the same manner as in Example 8 to obtain a conductive polymer composition.

(Example 12)

Except that the tetraethylammonium

hydrogencarbonate of Example 8 was changed to 0.130 g of 1-ethyl-3-n-butylimidazolium, preparation was carried out in the same manner as in Example 8 to obtain a conductive polymer composition.

(Example 13)

Except that the tetraethylammonium

hydrogencarbonate of Example 8 was changed to 0.150 g of 1,3-diisopropylimidazolium, preparation was carried out in the same manner as in Example 8 to obtain a conductive polymer composition.

(Example 14)

Except that the tetraethylammonium

hydrogencarbonate of Example 8 was changed to 0.170 g of 1,3-di-tert-butylimidazolium, preparation was carried out in the same manner as in Example 8 to obtain a conductive polymer composition.

(Comparative Example 1)

In ultrapure water in which 0.0710 g of triethylamine had been dissolved, 0.300 g of the brown powder of the polyaniline-based conductive polymer obtained in the Production Example was dissolved. After stirring the mixture at room temperature for 2 hours, the mixture was filtered through a polyethylene filter subjected to a hydrophilization treatment, and the resultant was obtained as Comparative Example 1.

(Comparative Example 2)

Except that the triethylamine of Comparative Example 1 was changed to 0.181 g of tetra-n-butylammonium hydroxide, preparation was carried out in the same manner as in Comparative Example 1, and the resultant was obtained as Comparative Example 2.

(Comparative Example 3)

Except that the triethylamine of Comparative Example 1 was changed to 0.107 g of diazabicycloundecene (DBU), the preparation was carried out in the same manner as in Comparative Example 1, and the resultant was obtained as Comparative Example 3.

(Comparative Example 4)

In ultrapure water in which 0.0710 g of triethylamine had been dissolved, 0.00450 g of acetylene glycol-based surfactant SURFYNOL 465 (available from Nissin Chemical Industry Co., Ltd.) was dissolved as a nonionic surfactant and 0.330 g of polyvinyl pyrrolidone (available from NACALAI TESQUE, INC.) was dissolved as a water-soluble polymer compound. Furthermore, 0.300 g of the brown powder of the polyaniline-based conductive polymer obtained in the Production Example was dissolved therein. After stirring the mixture at room temperature for 2 hours, the mixture was filtered through a polyethylene filter subjected to hydrophilization treatment, and the resultant was obtained as Comparative Example 4.

(Comparative Example 5)

Except that the triethylamine of Comparative Example 4 was changed to 0.181 g of tetra-n-butylammonium hydroxide, the preparation was carried out in the same manner as in Comparative Example 4, and the resultant was obtained as Comparative Example 5.

(Comparative Example 6)

Except that the triethylamine of Comparative Example 4 was changed to 0.107 g of diazabicycloundecene (DBU), the preparation was carried out in the same manner as in Comparative Example 4, and the resultant was obtained as Comparative Example 6.

(Resist for Evaluation)

In the evaluation as an antistatic film for lithography (for electron beam resist) by an electron beam, a positive chemically-amplified electron beam resist (RP-1) manufactured by Shin-Etsu Chemical Co., Ltd. was used as the positive chemically-amplified resist used in combination. In addition, as a negative chemically-amplified electron beam resist, (RP-2) manufactured by Shin-Etsu Chemical Co., Ltd. was used.

[Positive Resist Composition (R-1)]

In an organic solvent were dissolved a polymer (RP-1) (100 parts by mass), an acid generator P-1 (8 parts by mass), Q-1 (4 parts by mass) as an acid diffusion controller, and a surfactant, and the obtained respective solutions were filtered through a 0.02 μm-size UPE filter to prepare a positive resist composition.

[Negative Resist Composition (R-2)]

In an organic solvent were dissolved a polymer (RP-2) (100 parts by mass), an acid generator P-1 (5 parts by mass), a fluorine-containing polymer D1 (3 parts by mass), Q-1 (7 parts by mass) as a diffusion controller, and a surfactant, and the obtained respective solutions were filtered through a 0.02 μm-size UPE filter to prepare a negative resist composition.

In addition, PF-636 (available from OMNOVA SOLUTIONS Inc.) was added to each resist composition as a surfactant, and as the organic solvent, a mixed solvent of 1,204 parts by mass of propylene glycol monomethyl ether acetate (PGMEA), 1,204 parts by mass of ethyl lactate (EL), and 1,606 parts by mass of propylene glycol monomethyl ether (PGME) was used.

**Polymer (RP-1)**

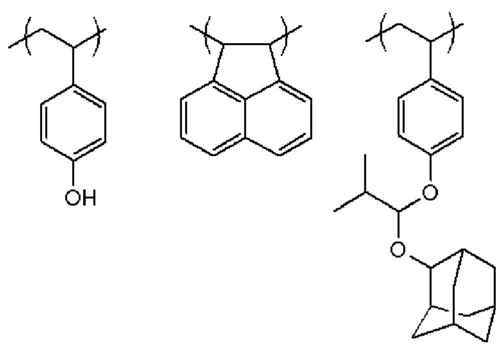

78 11 11

**Polymer (RP-2)**

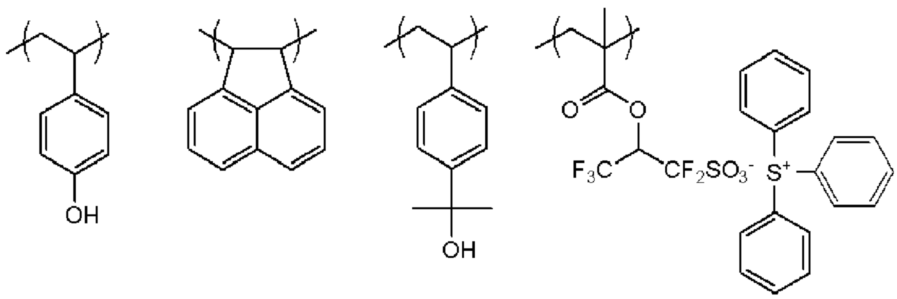

66.0 9.0 21.5 3.5

PAG (P-1)

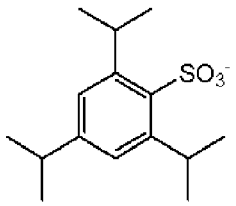 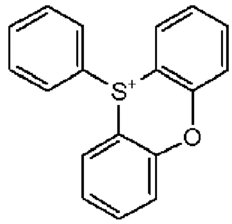

Quencher (Q-1)

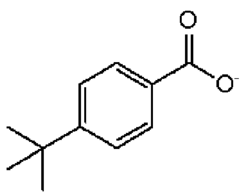 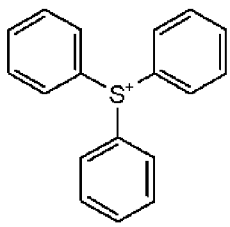

**Polymer (D-1)**

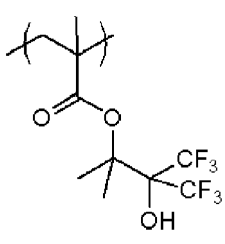 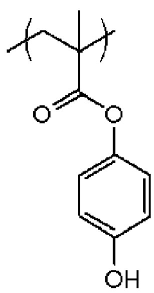

80 20

(Electron Beam Resist and Conductive Polymer Composition - Film Formation on Silicon Wafer)

(R-1) and (R-2) were applied by spin-coating on a silicon wafer having a diameter of 6 inches (150 mm) by using a coater developer clean track MARK VIII (manufactured by Tokyo Electron Limited), and subjected to baking in a precision thermostat at 110°C for 240 seconds and the solvent was removed to form a film. On the film, 2.0 mL of each of Examples 1 to 14 and Comparative Examples 1 to 6 was dropped respectively, and was applied by spin-coating on the whole resist film by using a spinner. The spin-coating conditions were so adjusted that the film thickness was 80 + 5 nm. Baking was carried out in a precision thermostat at 90°C for 5 minutes, and the solvent was removed to obtain an antistatic film. A resist film thickness and an antistatic film thickness were determined by an incident angle-variable spectroscopic ellipsometer VASE (manufactured by J.A. Woollam Co.).

(Film Formability of Conductive Composition)

Evaluation was carried out according to the following criteria: when the conductive polymer composition was formed into a uniform film on the electron beam resist in the film formation process of the above-described electron beam resist and conductive polymer composition, the composition was evaluated as "good"; and when the refractive index was successfully measured but defects originating from particles were generated or striations were partly generated in the film, the composition was evaluated as "poor". Table 2 shows the evaluation results.

(Peelability by Water Washing)

Each of the formed conductive polymer films was rinsed with ion-exchanged water from a wash bottle. Evaluation was carried out according to the following criteria: when the antistatic film was peeled off uniformly within 30 seconds, the composition was evaluated as "excellent"; and when the antistatic film was peeled off uniformly in 31 seconds or more and within 60 seconds, the composition was evaluated as "good". Table 2 shows the results.

(PH Measurement)

A pH of each of the conductive polymer compositions of Examples 1 to 14 and Comparative Examples 1 to 6 was measured by using a pH meter D-52 (manufactured by Horiba Ltd.). Table 2 shows the results.

(Surface Resistivity)

A surface resistivity (Ω/□) of each of the conductive polymer films of Examples 1 to 14 and Comparative Examples 1 to 6 obtained by the above-described film-forming method was measured by using Loresta-GP MCP-T610 (manufactured by Mitsubishi Chemical Corporation). Table 2 shows the results.

[Table 2]

| | Film-formability | Peelability by washing | pH | Surface resistivity (Ω/□) |
|---|---|---|---|---|
| Example 1 | Good | Excellent | 6.55 | 5.21E+08 |
| Example 2 | Good | Good | 6.87 | 6.32E+08 |
| Example 3 | Good | Excellent | 6.73 | 3.33E+08 |
| Example 4 | Good | Good | 6.55 | 6.10E+08 |
| Example 5 | Good | Excellent | 6.91 | 6.22E+08 |
| Example 6 | Good | Good | 6.66 | 7.51E+08 |
| Example 7 | Good | Good | 6.70 | 7.44E+08 |
| Example 8 | Good | Excellent | 6.85 | 2.55E+09 |
| Example 9 | Good | Excellent | 6.77 | 4.25E+09 |
| Example 10 | Good | Excellent | 6.67 | 3.11E+09 |
| Example 11 | Good | Excellent | 6.91 | 2.46E+09 |
| Example 12 | Good | Excellent | 6.90 | 2.89E+09 |

(continued)

| | Film-formability | Peelability by washing | pH | Surface resistivity (Ω/□) |
|---|---|---|---|---|
| Example 13 | Good | Excellent | 6.75 | 3.12E+09 |
| Example 14 | Good | Excellent | 6.82 | 3.72E+09 |
| Comparative Example 1 | Good | Good | 6.89 | 4.72E+09 |
| Comparative Example 2 | Good | Good | 6.98 | 5.11E+09 |
| Comparative Example 3 | Good | Excellent | 6.50 | 3.99E+09 |
| Comparative Example 4 | Good | Excellent | 6.87 | 4.00E+09 |
| Comparative Example 5 | Good | Excellent | 6.94 | 7.00E+09 |
| Comparative Example 6 | Good | Excellent | 6.89 | 5.92E+09 |

(Evaluation of Change Rate of Film Loss)

The effect of diffusion of the acid from the conductive polymer film to the resist film or diffusion of the additive to the resist film appears in the film after development when the positive resist is applied. Thereafter, a film of each of Examples 1 to 14 and Comparative Examples 1 to 6 was formed on the positive resist (R-1), and a change rate of film loss of the resist film was measured when a resist pattern was obtained by development through a peeling process before PEB or a peeling process after PEB of the conductive polymer composition formed into a film after the electron beam writing.

Evaluation of Peeling Process before PEB

The positive chemically-amplified resist (R-1) was applied by spin-coating onto a 6-inch silicon wafer by using MARK VIII (manufactured by Tokyo Electron Limited, coater developer clean track), and pre-baked on a hot plate at 110°C for 240 seconds to prepare an 80-nm resist film <film thickness (T1)>. The conductive polymer composition was applied by spin-coating onto the obtained wafer with the resist film by using MARK VIII in the same manner as above, and baked on a hot plate at 90°C for 90 seconds to prepare a 20-nm conductive polymer film. Further, the film was exposed using an electron beam exposure apparatus (HL-800D, manufactured by Hitachi High-Technologies Corporation, acceleration voltage 50 keV), thereafter, the conductive polymer film was peeled off by flowing pure water for 30 seconds, and then, baking at 90°C for 240 seconds (PEB: post exposure bake) was performed and development with a 2.38 mass% aqueous solution of tetramethylammonium hydroxide was carried out to obtain a positive pattern <film thickness (T3) at unexposed portion>.

Evaluation of Peeling Process after PEB

The positive chemically-amplified resist (R-1) was applied by spin-coating onto a 6-inch silicon wafer by using MARK VIII (manufactured by Tokyo Electron Limited, coater developer clean track), and pre-baked on a hot plate at 110°C for 240 seconds to prepare an 80-nm resist film <film thickness (T1)>. The conductive polymer composition was applied by spin-coating onto the obtained wafer with the resist film by using MARK VIII in the same manner as above, and baked on a hot plate at 90°C for 90 seconds to prepare a 20-nm conductive polymer film. Furthermore, the film was exposed using an electron beam exposure apparatus (HL-800D, manufactured by Hitachi High-Technologies Corporation, acceleration voltage 50 keV), and then, baking at 90°C for 240 seconds (PEB: post exposure bake) was performed, and development with a 2.38 mass% aqueous solution of tetramethylammonium hydroxide was carried out to obtain a positive pattern <film thickness (T3) at unexposed portion>.

The same operation as the peeling process after PEB was also carried out on the resist film to which no conductive polymer film was provided, and an optimum exposure amount after exposure and development and a resist film thickness (T2) at the unexposed portion were obtained, and according to the following equation, a change rate of film loss (change rate of film thickness) was obtained in each of the peeling process before PEB and the peeling process after PEB of the conductive polymer film.

$$\text{Change rate of film loss (\%)} = [\{(T1-T3)-(T1-T2)\}/(T1-T2)] \times 100$$

Table 3 shows the results.

[Table 3]

| | Change rate of film loss (%) | |
|---|---|---|
| | Peeling process before PEB | Peeling process after PEB |
| Resist | (R-1) | (R-1) |
| Example 1 | 16.7 | 20.1 |
| Example 2 | 15.0 | 18.8 |
| Example 3 | 17.3 | 21.0 |
| Example 4 | 15.7 | 18.4 |
| Example 5 | 14.2 | 19.0 |
| Example 6 | 16.1 | 18.1 |
| Example 7 | 18.4 | 20.3 |
| Example 8 | 14.5 | 18.4 |
| Example 9 | 13.7 | 17.2 |
| Example 10 | 14.1 | 16.9 |
| Example 11 | 13.9 | 17.1 |
| Example 12 | 13.0 | 19.0 |
| Example 13 | 13.2 | 15.2 |
| Example 14 | 13.2 | 14.9 |
| Comparative Example 1 | 26.0 | 32.1 |
| Comparative Example 2 | 24.2 | 29.2 |
| Comparative Example 3 | 24.3 | 27.7 |
| Comparative Example 4 | 25.2 | 31.1 |
| Comparative Example 5 | 24.0 | 28.6 |
| Comparative Example 6 | 27.6 | 28.4 |

(Evaluation of Electron Beam Writing Resolution)

A resist pattern obtained by the following process by using the resist film and conductive film formed on a mask blank was evaluated.

Evaluation of Peeling Process before PEB

The resist composition prepared as described above was applied by spin-coating onto a 152-mm square mask blank, the outermost surface of which was a chromium oxide nitride film, by using ACT-M (manufactured by Tokyo Electron Limited), and pre-baked on a hot plate at 110°C for 600 seconds to prepare an 80-nm resist film. Measurement of the film thickness of the obtained resist film was carried out with an optical measurement apparatus Nanospec (manufactured by Nanometrics). The measurement was carried out at 81 portions in the plane of the blank substrate excluding the outer periphery from the outer edge of the blank to 10 mm inward, and an average value of the film thickness and a range of the film thickness were calculated. The conductive polymer compositions of Examples 1 to 14 and Comparative Examples 1 to 6 were respectively applied by spin-coating onto the mask blank with the resist film thus

obtained, and baked on a hot plate at 90°C for 90 seconds to prepare a 20-nm conductive polymer film. Subsequently, the film was exposed using an electron beam exposure apparatus (EBM-5000plus manufactured by NuFlare Technology Inc., acceleration voltage 50 kV), peeled by washing with ultrapure water for 20 seconds, then subjected to PEB at 110°C for 600 seconds, and developed with a 2.38 mass% aqueous TMAH solution to obtain patterns of a positive resist (R-1) and a negative resist (R-2).

The obtained resist pattern was evaluated as follows. The prepared mask blank with the pattern was observed with a sky SEM (scanning electron microscope). The exposure amount which resolves 1:1 line-and-space (LS) of 200 nm with 1:1 was set as the optimum exposure amount (sensitivity) ($\mu C/cm^2$), and the minimum dimension at the exposure amount to resolve 200-nm LS with 1:1 was obtained as the resolution (limiting resolution). The edge roughness (LER) of the 200-nm LS was measured by SEM. Regarding the pattern profile, it was visually judged whether or not the pattern profile was rectangular. Table 4 shows the results using the positive resist (R-1), and Table 5 shows the results using the negative resist.

[Table 4]

| | Sensitivity ($\mu C/cm^2$) | Limiting resolution (nm) | Edge roughness LER | Pattern profile |
|---|---|---|---|---|
| Resist (R-1) alone | 52.5 | 40 | 6.1 | Rectangle |
| Example 1 | 53.4 | 40 | 5.6 | Rectangle |
| Example 2 | 53.8 | 40 | 5.8 | Rectangle |
| Example 3 | 54.3 | 40 | 6.0 | Rectangle |
| Example 4 | 53.8 | 40 | 5.8 | Rectangle |
| Example 5 | 53.6 | 40 | 6.1 | Rectangle |
| Example 6 | 53.6 | 40 | 5.7 | Rectangle |
| Example 7 | 53.7 | 40 | 5.9 | Rectangle |
| Example 8 | 53.0 | 40 | 5.5 | Rectangle |
| Example 9 | 52.8 | 40 | 5.5 | Rectangle |
| Example 10 | 53.9 | 40 | 5.7 | Rectangle |
| Example 11 | 52.6 | 40 | 5. 6 | Rectangle |
| Example 12 | 52.9 | 40 | 5.4 | Rectangle |
| Example 13 | 52.6 | 40 | 5.4 | Rectangle |
| Example 14 | 52.8 | 40 | 5.5 | Rectangle |
| Comparative Example 1 | 73.8 | 150 | 8.3 | Top rounding |
| Comparative Example 2 | 71.2 | 150 | 8.6 | Top rounding |
| Comparative Example 3 | 68.5 | 100 | 7.2 | Rectangle |
| Comparative Example 4 | 65.2 | 100 | 8.0 | Top rounding |
| Comparative Example 5 | 64.0 | 100 | 8.5 | Top rounding |
| Comparative Example 6 | 62.5 | 100 | 6.8 | Rectangle |

[Table 5]

| | Sensitivity ($\mu C/cm^2$) | Limiting resolution (nm) | Edge roughness LER | Pattern profile |
|---|---|---|---|---|
| Resist (R-2) alone | 48.0 | 35 | 5.9 | Rectangle |
| Example 1 | 46.8 | 35 | 5.3 | Rectangle |
| Example 2 | 46.8 | 35 | 5.5 | Rectangle |
| Example 3 | 45.3 | 35 | 5.3 | Rectangle |

(continued)

| | Sensitivity ($\mu C/cm^2$) | Limiting resolution (nm) | Edge roughness LER | Pattern profile |
|---|---|---|---|---|
| Example 4 | 46.0 | 35 | 5.8 | Rectangle |
| Example 5 | 46.4 | 35 | 5.4 | Rectangle |
| Example 6 | 46.5 | 35 | 5.5 | Rectangle |
| Example 7 | 46.6 | 35 | 5.2 | Rectangle |
| Example 8 | 47.3 | 35 | 5.6 | Rectangle |
| Example 9 | 48.2 | 35 | 5.8 | Rectangle |
| Example 10 | 47.5 | 35 | 5.3 | Rectangle |
| Example 11 | 47.0 | 35 | 5. 6 | Rectangle |
| Example 12 | 47.5 | 35 | 5.8 | Rectangle |
| Example 13 | 47.4 | 35 | 5.3 | Rectangle |
| Example 14 | 47.0 | 35 | 5.9 | Rectangle |
| Comparative Example 1 | 36.3 | 100 | 7.8 | T top |
| Comparative Example 2 | 39.1 | 100 | 8.3 | T top |
| Comparative Example 3 | 42.9 | 80 | 7.9 | Rectangle |
| Comparative Example 4 | 38.2 | 80 | 9.2 | T top |
| Comparative Example 5 | 37.9 | 80 | 8.5 | T top |
| Comparative Example 6 | 45.8 | 80 | 8.1 | Rectangle |

Evaluation of Peeling Process after PEB

The resist composition prepared as described above was applied by spin-coating onto a 152-mm square mask blank, the outermost surface of which was a chromium oxide nitride film, by using ACT-M (manufactured by Tokyo Electron Limited), and pre-baked on a hot plate at 110°C for 600 seconds to prepare an 80-nm resist film. Measurement of the film thickness of the obtained resist film was carried out with an optical measurement apparatus Nanospec (manufactured by Nanometrics). The measurement was carried out at 81 portions in the plane of the blank substrate excluding the outer periphery from the outer edge of the blank to 10 mm inward, and an average value of the film thickness and a range of the film thickness were calculated. The conductive polymer compositions of Examples 1 to 14 and Comparative Examples 1 to 6 were respectively applied by spin-coating onto the wafer with the resist film thus obtained, and baked on a hot plate at 90°C for 90 seconds to prepare a 20-nm conductive polymer film. Subsequently, the film was exposed using an electron beam exposure apparatus (EBM-5000plus manufactured by NuFlare Technology Inc., acceleration voltage 50 kV), then subjected to PEB at 110°C for 600 seconds, and developed with a 2.38 mass% aqueous TMAH solution to obtain patterns of a positive resist (R-1) and a negative resist (R-2).

The obtained resist pattern was evaluated as follows. The prepared mask blank with the pattern was observed with a sky SEM (scanning electron microscope). The exposure amount which resolves 1:1 line-and-space

(LS) of 200 nm with 1:1 was set as the optimum exposure amount (sensitivity) ($\mu C/cm^2$), and the minimum dimension at the exposure amount to resolve 200-nm LS with 1:1 was obtained as the resolution (limiting resolution). The edge roughness (LER) of the 200-nm LS was measured by SEM. Regarding the pattern profile, it was visually judged whether or not the pattern profile was rectangular. Table 6 shows the results using the positive resist (R-1), and Table 7 shows the results using the negative resist.

[Table 6]

| | Sensitivity ($\mu C/cm^2$) | Limiting resolution (nm) | Edge roughness LER | Pattern profile |
|---|---|---|---|---|
| Resist (R-1) alone | 52.5 | 40 | 6.1 | Rectangle |
| Example 1 | 57.6 | 40 | 5.6 | Rectangle |
| Example 2 | 58.9 | 40 | 5.4 | Rectangle |

(continued)

| | Sensitivity (μC/cm2) | Limiting resolution (nm) | Edge roughness LER | Pattern profile |
|---|---|---|---|---|
| Example 3 | 57.3 | 40 | 5.6 | Rectangle |
| Example 4 | 53.9 | 40 | 5.8 | Rectangle |
| Example 5 | 53.7 | 40 | 5.7 | Rectangle |
| Example 6 | 53.6 | 40 | 5.5 | Rectangle |
| Example 7 | 54.5 | 40 | 5.6 | Rectangle |
| Example 8 | 54.0 | 40 | 5.4 | Rectangle |
| Example 9 | 53.6 | 40 | 5.4 | Rectangle |
| Example 10 | 55.8 | 40 | 5.5 | Rectangle |
| Example 11 | 52.8 | 40 | 5. 6 | Rectangle |
| Example 12 | 53.2 | 40 | 5.3 | Rectangle |
| Example 13 | 53.0 | 40 | 5.4 | Rectangle |
| Example 14 | 52.9 | 40 | 5.5 | Rectangle |
| Comparative Example 1 | 90.7 | >200 | 8.3 | Top rounding |
| Comparative Example 2 | 92.9 | >200 | 8.6 | Top rounding |
| Comparative Example 3 | 76.3 | 200 | 7.2 | Rectangle |
| Comparative Example 4 | 80.3 | >200 | 8.0 | Top rounding |
| Comparative Example 5 | 83.1 | >200 | 8.5 | Top rounding |
| Comparative Example 6 | 72.0 | 200 | 6.8 | Rectangle |

[Table 7]

| | Sensitivity (μC/cm2) | Limiting resolution (nm) | Edge roughness LER | Pattern profile |
|---|---|---|---|---|
| Resist (R-2) alone | 48.0 | 35 | 5.9 | Rectangle |
| Example 1 | 47.3 | 35 | 5.7 | Rectangle |
| Example 2 | 47.2 | 35 | 5.0 | Rectangle |
| Example 3 | 47.2 | 35 | 5.3 | Rectangle |
| Example 4 | 47.0 | 35 | 5.8 | Rectangle |
| Example 5 | 47.2 | 35 | 5.4 | Rectangle |
| Example 6 | 47.5 | 35 | 5.2 | Rectangle |
| Example 7 | 47.7 | 35 | 5.2 | Rectangle |
| Example 8 | 47.3 | 35 | 6.1 | Rectangle |
| Example 9 | 47.5 | 35 | 5.6 | Rectangle |
| Example 10 | 47.5 | 35 | 5.9 | Rectangle |
| Example 11 | 47.6 | 35 | 5.7 | Rectangle |
| Example 12 | 47.2 | 35 | 5.9 | Rectangle |
| Example 13 | 47.8 | 35 | 5.8 | Rectangle |
| Example 14 | 47.8 | 35 | 5.3 | Rectangle |
| Comparative Example 1 | 30.2 | 100 | 8.2 | T top |

(continued)

| | Sensitivity ($\mu C/cm^2$) | Limiting resolution (nm) | Edge roughness LER | Pattern profile |
|---|---|---|---|---|
| Comparative Example 2 | 31.9 | 100 | 8.3 | T top |
| Comparative Example 3 | 40.4 | 80 | 6.9 | T top |
| Comparative Example 4 | 33.3 | 100 | 8.0 | T top |
| Comparative Example 5 | 35.9 | 100 | 8.7 | T top |
| Comparative Example 6 | 44.6 | 60 | 6.6 | T top |

In Table 2, in each of Examples 1 to 14 and Comparative Examples 1 to 6, film-formability on the electron beam resist by spin-coating was excellent, and a uniform film was formed. Meanwhile, regarding peelability by water washing, the peeling efficiency was high in Examples 8 to 14 and Comparative Examples 4 to 6, where the surfactant (C) SURFYNOL 465 and the water-soluble polymer (D) polyvinyl pyrrolidone (available from NACALAI TESQUE, INC.) were contained. No clear difference was observed between the Examples and the Comparative Examples, but regarding peelability by water washing, the effectiveness of adding (C) and the water-soluble polymer (D) was confirmed.

In Examples 1 to 14, the conductive polymer composition contained hydrogencarbonate as the component (B) with regard to the polyaniline-based polymer compound of the component (A). Therefore, the component (B) exerted an ion exchange effect on the sulfonic acid terminal of the component (A), and the pH was 6.5 to 7.0, around neutral. In Comparative Examples 1 to 6, the strong base component, which was contained for comparison with the component (B), exerted a neutralizing effect directly on the sulfonic acid terminal of the component (A), and the pH was around neutral. These results are the physical properties in the liquid state before film formation, and therefore, the effectiveness of the Examples compared with the Comparative Examples is not clear. However, when the conductive polymer compositions are applied onto an electron beam resist to form a film and go through electron beam writing and PEB processes, a clear difference is exhibited in lithography.

In Table 3, each of Examples 1 to 14 and Comparative Examples 1 to 6 was respectively formed into a film on a positive electron beam resist (R-1), and the film loss rate was compared on the basis of the lithography results obtained by resist pattern development through a peeling process before PEB and PEB, or collective resist pattern development after PEB without a peeling process before PEB. As a result, in Examples 1 to 14, the film loss rate was low and in the range of 13 to 21% after either resist patterning process, whereas in Comparative Examples 1 to 6, the film loss rate was a high value of 24 to 32%. The component (B) of Examples 1 to 14 has a neutralizing function achieved by ion exchange using hydrogencarbonate, and therefore, the hydrogencarbonate ions that received an acid tend to shift to carbon dioxide. After the neutralization, there is a possibility that the component (B) may remain in the film after film formation and diffuse to an upper layer of the resist film from the interface with the electron beam resist. However, since the component (B) is a salt, the component (B) has less influence by a chemical reaction on constituents of the resist before writing compared with strongly basic substances. On the other hand, in the case of the strongly basic substance in Comparative Examples 1 to 6, the strongly basic substance made a nucleophilic attack on a hydrolysable partial structure of the constituents of the resist in an upper layer of the resist film from the interface with the electron beam resist from before the writing, and generated elements that promoted decomposition and excessive acid diffusion and so forth. This increased the film loss rate after development of the resist formed with a particular film thickness.

Tables 4 to 7 show the results of resist lithography evaluation after respectively forming a film of each of Examples 1 to 14 and Comparative Examples 1 to 6 on a positive electron beam resist (R-1) or a negative electron beam resist (R-2), and then performing resist pattern development through a process of peeling by water washing after writing and through PEB, or performing a process of peeling at the same time as collective resist pattern development after PEB without a process of peeling by water washing after writing. Optimum exposure amount ($\mu C/cm^2$), resolution (limiting resolution), edge roughness (LER), and pattern profile were compared, and in Examples 1 to 14, there was little change in sensitivity, the limiting resolution and roughness (LER) were both of the same level as those in the lithography of the resist alone without applying the conductive polymer composition, and the pattern profile after development maintained a rectangular profile, so that the resist performance was not degraded in both of the above resist types and after either of the resist patterning processes. On the other hand, in Comparative Examples 1 to 6, effects on resist constituents in the interface with the electron beam resist or in the upper layer of the resist was great, as stated above, and the sensitivity of the electron beam resist and lithography performance were affected. Thus, the resolution, roughness (LER), and pattern profile were greatly degraded compared with the lithography of only the resist.

(Evaluation of Electron Beam Lithography and Evaluation of PCD (Post Coating Delay))

Next, change with a lapse of time due to the effect of the conductive polymer film on the resist film before irradiation with the electron beam was measured. The two-layered film of the resist film and the conductive polymer film provided by coating according to the method described below was allowed to stand immediately after film formation for 7 days, 14 days, and 30 days in the electron beam writing apparatus, and then, a resist pattern was obtained by the peeling process before PEB or the peeling process after PEB of the conductive polymer film as described below. Change in the pattern line width at the sensitivity when the resist and conductive polymer films were drawn immediately after film formation was obtained.

Evaluation of Peeling Process before PEB

The positive chemically-amplified resist (R-1) was applied by spin-coating on a 6-inch silicon wafer by using MARK VIII (manufactured by Tokyo Electron Limited, coater developer clean track), and subjected to prebaking on a hot plate at 110°C for 240 seconds to obtain a resist film having a film thickness of 80 nm. The conductive polymer composition was applied by spin-coating onto the obtained wafer with the resist film in the same manner as above by using MARK VIII, and baked on a hot plate at 90°C for 90 seconds to prepare a conductive polymer film. With regard to the wafer onto which the two-layered film of the resist film and the conductive polymer film had been provided by coating, resist patterns were obtained immediately after being provided by coating, after 7 days, after 14 days, and after 30 days, respectively, by the following methods. First, with regard to the wafer immediately after being provided by coating, it was exposed by using an electron beam exposure apparatus (HL-800D, manufactured by Hitachi High-Technologies Corporation, acceleration voltage 50 keV), thereafter, the conductive polymer film was peeled off by flowing pure water for 30 seconds, and then, the resultant was subjected to baking at 110°C for 240 seconds (PEB: post exposure bake) and developed with a 2.38 mass% aqueous tetramethylammonium hydroxide solution. The prepared wafer with the pattern was observed with a sky SEM (scanning electron microscope), and an exposure amount which resolves line-and-space of 400 nm with 1:1 was set as an optimum exposure amount (sensitivity) ($\mu C/cm^2$). A minimum dimension at the optimum exposure amount was set as a resolution. In addition, with regard to the wafers after 7 days, 14 days, and 30 days had passed after being provided by coating, resist patterns were similarly obtained, and change in the pattern line width at the exposure amount (optimum exposure amount (sensitivity) ($\mu C/cm^2$)) which resolves line-and-space of 200 nm with 1:1 in the wafer immediately after being provided by coating was measured. The results are shown in Table 8.

Evaluation of Peeling Process after PEB

In the same manner as in the peeling process before PEB, wafers onto which the two-layered film of the resist film and the conductive polymer film had been provided by coating were prepared, and with regard to the respective wafers after 7 days, 14 days, and 30 days had passed after being provided by coating, they were subjected to baking at 110°C for 240 seconds (PEB: post exposure bake) without subjecting to the process of peeling the conductive polymer film by flowing pure water for 20 seconds after the electron beam exposure, and developed with a 2.38 mass% aqueous tetramethylammonium hydroxide solution to obtain a resist pattern. Change in the pattern line width at the exposure amount (optimum exposure amount (sensitivity) ($\mu C/cm^2$)) which resolves line-and-space of 200 nm with 1:1 in the wafer immediately after being provided by coating was measured. The results are shown in Table 9.

With regard to the negative resist (R-2), the same evaluation as the above-described positive resist (R-1) was carried out for the peeling process before PEB and the peeling process after PEB. The results are shown in Table 10 and Table 11.

[Table 8]

| Positive resist (R-1) peeling process before PEB, PCD | | | | |
|---|---|---|---|---|
| | PCD line width variation (nm) | | | |
| | Immediately after coating | 7 days | 14 days | 30 days |
| Example 1 | 0 | -0.5 | -0.8 | -1.8 |
| Example 2 | 0 | -0.5 | -0.6 | -1.5 |
| Example 3 | 0 | -0.5 | -0.8 | -1.8 |
| Example 4 | 0 | -0.4 | -0.6 | -1.4 |
| Example 5 | 0 | -0.5 | -0.8 | -1.3 |

(continued)

| Positive resist (R-1) peeling process before PEB, PCD | | | | |
|---|---|---|---|---|
| | PCD line width variation (nm) | | | |
| | Immediately after coating | 7 days | 14 days | 30 days |
| Example 6 | 0 | -0.4 | -0.5 | -1.3 |
| Example 7 | 0 | -0.5 | -0.6 | -1.2 |
| Example 8 | 0 | -0.0 | -0.5 | -1.2 |
| Example 9 | 0 | -0.2 | -0.5 | -1.2 |
| Example 10 | 0 | -0.3 | -0.5 | -1.0 |
| Example 11 | 0 | -0.2 | -0.4 | -1.2 |
| Example 12 | 0 | -0.2 | -0.4 | -1.1 |
| Example 13 | 0 | -0.2 | -0.4 | -1.0 |
| Example 14 | 0 | -0.2 | -0.4 | -1.0 |
| Comparative Example 1 | 0 | -4.5 | -10.3 | -16.0 |
| Comparative Example 2 | 0 | -4.8 | -10.0 | -16.7 |
| Comparative Example 3 | 0 | -2.1 | -5.3 | -10.7 |
| Comparative Example 4 | 0 | -4.1 | -10.7 | -15.7 |
| Comparative Example 5 | 0 | -4.2 | -9.2 | -15.3 |
| Comparative Example 6 | 0 | -2.0 | -4.8 | -8.8 |

[Table 9]

| Positive resist (R-1) peeling process after PEB, PCD | | | | |
|---|---|---|---|---|
| | PCD line width variation (nm) | | | |
| | Immediately after coating | 7 days | 14 days | 30 days |
| Example 1 | 0 | -0.5 | -1.1 | -2.0 |
| Example 2 | 0 | -0.5 | -1.0 | -1.7 |
| Example 3 | 0 | -0.5 | -1.2 | -2.0 |
| Example 4 | 0 | -0.4 | -0.7 | -1.6 |
| Example 5 | 0 | -0.5 | -0.8 | -1.6 |
| Example 6 | 0 | -0.4 | -0.6 | -1.5 |
| Example 7 | 0 | -0.5 | -0.6 | -1.5 |
| Example 8 | 0 | -0.5 | -0.5 | -1.4 |
| Example 9 | 0 | -0.3 | -0.5 | -1.4 |
| Example 10 | 0 | -0.6 | -0.5 | -1.3 |
| Example 11 | 0 | -0.3 | -0.6 | -1.3 |
| Example 12 | 0 | -0.3 | -0.5 | -1.3 |
| Example 13 | 0 | -0.3 | -0.5 | -1.2 |
| Example 14 | 0 | -0.3 | -0.5 | -1.2 |
| Comparative Example 1 | 0 | -6.5 | -12.9 | -22.0 |

(continued)

| Positive resist (R-1) peeling process after PEB, PCD | | | | |
|---|---|---|---|---|
| | PCD line width variation (nm) | | | |
| | Immediately after coating | 7 days | 14 days | 30 days |
| Comparative Example 2 | 0 | -5.8 | -12.1 | -19.8 |
| Comparative Example 3 | 0 | -3.1 | -7.8 | -11.7 |
| Comparative Example 4 | 0 | -6.1 | -13.7 | -19.7 |
| Comparative Example 5 | 0 | -6.2 | -11.2 | -20.3 |
| Comparative Example 6 | 0 | -2.7 | -7.0 | -10.8 |

[Table 10]

| Negative resist (R-2) peeling process before PEB, PCD | | | | |
|---|---|---|---|---|
| | PCD line width variation (nm) | | | |
| | Immediately after coating | 7 days | 14 days | 30 days |
| Example 1 | 0 | 0.2 | 0.4 | 1.3 |
| Example 2 | 0 | 0.3 | 0.5 | 1.2 |
| Example 3 | 0 | 0.2 | 0.7 | 1.4 |
| Example 4 | 0 | 0.2 | 0.4 | 1.1 |
| Example 5 | 0 | 0.3 | 0.5 | 1.0 |
| Example 6 | 0 | 0.2 | 0.3 | 0.9 |
| Example 7 | 0 | 0.2 | 0.3 | 0.9 |
| Example 8 | 0 | 0.2 | 0.3 | 0.8 |
| Example 9 | 0 | 0.2 | 0.3 | 0.8 |
| Example 10 | 0 | 0.3 | 0.3 | 0.6 |
| Example 11 | 0 | 0.2 | 0.4 | 0.8 |
| Example 12 | 0 | 0.3 | 0.5 | 0.8 |
| Example 13 | 0 | 0.2 | 0.2 | 0.6 |
| Example 14 | 0 | 0.2 | 0.2 | 0.7 |
| Comparative Example 1 | 0 | 4.8 | 11.5 | 18.4 |
| Comparative Example 2 | 0 | 5.1 | 12.9 | 20.2 |
| Comparative Example 3 | 0 | 4.1 | 9.5 | 16.4 |
| Comparative Example 4 | 0 | 4.4 | 9.2 | 17.0 |
| Comparative Example 5 | 0 | 4.9 | 9.5 | 22.2 |
| Comparative Example 6 | 0 | 3.4 | 10.0 | 15.7 |

[Table 11]

| Negative resist (R-2) peeling process after PEB, PCD | | | | |
|---|---|---|---|---|
| | PCD line width variation (nm) | | | |
| | Immediately after coating | 7 days | 14 days | 30 days |
| Example 1 | 0 | 0.3 | 0.6 | 1.5 |
| Example 2 | 0 | 0.4 | 0.5 | 1.6 |
| Example 3 | 0 | 0.3 | 0.5 | 1.8 |
| Example 4 | 0 | 0.3 | 0.4 | 1.6 |
| Example 5 | 0 | 0.3 | 0.3 | 1.9 |
| Example 6 | 0 | 0.3 | 0.3 | 1.6 |
| Example 7 | 0 | 0.3 | 0.3 | 1.5 |
| Example 8 | 0 | 0.2 | 0.3 | 1.4 |
| Example 9 | 0 | 0.2 | 0.3 | 1.4 |
| Example 10 | 0 | 0.3 | 0.3 | 1.5 |
| Example 11 | 0 | 0.4 | 0.5 | 1.6 |
| Example 12 | 0 | 0.4 | 0.7 | 1.5 |
| Example 13 | 0 | 0.2 | 0.3 | 1.4 |
| Example 14 | 0 | 0.3 | 0.3 | 1.5 |
| Comparative Example 1 | 0 | 5.5 | 9.8 | 28.0 |
| Comparative Example 2 | 0 | 5.9 | 7.9 | 26.3 |
| Comparative Example 3 | 0 | 5.0 | 7.5 | 20.5 |
| Comparative Example 4 | 0 | 5.0 | 6.5 | 24.5 |
| Comparative Example 5 | 0 | 5.4 | 8.0 | 27.9 |
| Comparative Example 6 | 0 | 4.8 | 5.5 | 19.6 |

As shown in Tables 8 to 11, in the evaluation of the PCD (Post Coating Delay), the influence of the acid from the conductive polymer film to the electron beam resist layer after film formation was suppressed in Examples 1 to 14 by the effect of the hydrogencarbonate contained in the composition, and the storage stability of the resist film was successfully maintained good. That is, in a covered material of the resist film and the conductive polymer film (antistatic film) thereon before the electron beam writing, good lithographic results were successfully obtained by suppressing the diffusion of the acid from the conductive polymer film to the resist film. On the other hand, the compositions of Comparative Examples 1 to 6 alleviate (neutralize) the acidity of the composition efficiently by strongly basic substances and show liquid property near to neutral, but after film formation, these strongly basic substances (even after receiving an acid to form a cation) cause modification in the surface of the resist layer from the interface with the electron beam resist to resist film upper layer, or make a nucleophilic attack on the hydrolysable partial structure of the constitutional elements of the resist, thus promoting decomposition, excessive acid diffusion, and so forth. This adversely affects the sensitivity of the resist and lithography. This adverse effect is greater the longer the time taken to form a film on the upper layer of the resist layer, and the effect is great even in a peeling process before PEB.

As described above, when the inventive conductive polymer composition is employed, it is possible to form an antistatic film having excellent antistatic property at the time of writing to the electron beam resist and minimizing the effect of the acid to the resist. The composition having such an effective antistatic property and capable of preventing the effect of the acid is also effective as a constitutional film of an organic thin film device. In addition, the composition suppresses the effect of the acid to the adjacent layer and has functions such as conductivity and carrier transfer medium in the laminated structure, and the composition can also be suitably used as a device constituting material.

The present description includes the following inventions.

[1]: A conductive polymer composition comprising:

(A) a polyaniline-based conductive polymer having at least one kind of a repeating unit represented by the following general formula (1); and
(B) a hydrogencarbonate including a cation represented by the following general formula (2-1) or (2-2),

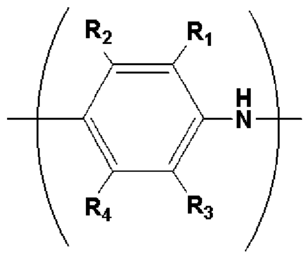

(1)

wherein $R_1$ to $R_4$ each independently represent a hydrogen atom, an acidic group, a hydroxy group, a nitro group, a halogen atom, a linear or branched alkyl group having 1 to 24 carbon atoms, a linear, branched, or cyclic hydrocarbon group having 1 to 24 carbon atoms containing a hetero atom, or a linear, branched, or cyclic hydrocarbon group having 1 to 24 carbon atoms partially substituted with a halogen atom,

$X^+$ (2-1)

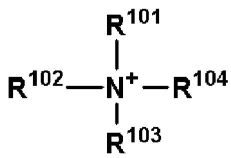

(2-2)

wherein X represents a monovalent alkali metal selected from lithium, sodium, potassium, and cesium, $R^{101}$, $R^{102}$, $R^{103}$, and $R^{104}$ each represent a hydrogen atom, a linear, branched, or cyclic alkyl group, alkenyl group, oxoalkyl group, or oxoalkenyl group having 1 to 12 carbon atoms, an aryl group having 6 to 20 carbon atoms, or an aralkyl group or aryloxoalkyl group having 7 to 12 carbon atoms, part or all of hydrogen atoms of these groups optionally being substituted with an alkoxy group or a hydroxy group and the groups optionally containing a hetero atom, $R^{101}$ and $R^{102}$, $R^{103}$ and $R^{104}$, and $R^{101}$, $R^{102}$, and $R^{104}$ optionally form a ring, and when a ring is formed, $R^{101}$ and $R^{102}$, $R^{103}$ and $R^{104}$, and $R^{101}$, $R^{102}$, and $R^{104}$ represent an alkylene group having 3 to 12 carbon atoms and optionally containing a hetero atom or represent a group including a heteroaromatic ring having the nitrogen atom in the formula in the ring, and $R^{101}$ and $R^{102}$ are optionally combined to form a group that is bonded with the nitrogen atom in the formula by a double bond, $R^{101}$ and $R^{102}$ optionally containing a hetero atom in this case.

[2]: The conductive polymer composition of the above [1], wherein the acidic group is a sulfo group.

[3]: The conductive polymer composition of the above [1] or [2], wherein the component (B) is contained in an amount of 1 part by mass to 150 parts by mass based on 100 parts by mass of the component (A).

[4]: The conductive polymer composition of any one of the above [1] to [3], further comprising (C) a nonionic surfactant.

[5]: The conductive polymer composition of the above [4], wherein the component (C) is contained in an amount of 0.1 parts by mass to 10 parts by mass based on 100 parts by mass of the component (A).

[6]: The conductive polymer composition of any one of the above [1] to [5], further comprising (D) a water-soluble polymer.

[7]: The conductive polymer composition of the above [6], wherein the component (D) is contained in an amount of 30 parts by mass to 150 parts by mass based on 100 parts by mass of the component (A).

[8]: A coated product comprising a film of the conductive polymer composition according to any one of the above [1] to [7] formed on a body to be processed.

[9]: The coated product of the above [8], wherein the body to be processed is a substrate comprising a chemically-amplified resist film.

[10]: The coated product of the above [9], wherein the body to be processed is a substrate for obtaining a resist pattern by pattern irradiation using an electron beam.

[11]: The coated product of the above [9] or [10], wherein the body to be processed is a substrate comprising a chemically-amplified electron beam resist film having a sensitivity of 20 $\mu C/cm^2$ or more.

[12]: A patterning process comprising the steps of:

forming an antistatic film on a resist film of a substrate provided with a chemically-amplified resist film by using the conductive polymer composition according to any one of the above [1] to [7];
performing pattern irradiation by using an electron beam; and
developing the substrate by using $H_2O$ or an alkaline developer to obtain a resist pattern.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

**1.** A conductive polymer composition comprising:

(A) a polyaniline-based conductive polymer having at least one kind of a repeating unit represented by the following general formula (1); and
(B) a hydrogencarbonate including a cation represented by the following general formula (2-1) or (2-2),

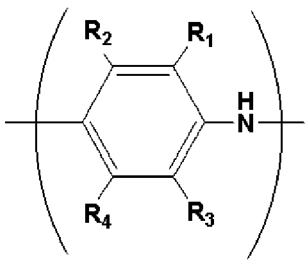

**( 1 )**

wherein $R_1$ to $R_4$ each independently represent a hydrogen atom, an acidic group, a hydroxy group, a nitro group, a halogen atom, a linear or branched alkyl group having 1 to 24 carbon atoms, a linear, branched, or cyclic hydrocarbon group having 1 to 24 carbon atoms containing a hetero atom, or a linear, branched, or cyclic hydrocarbon group having 1 to 24 carbon atoms partially substituted with a halogen atom,

$X^+$ **(2-1)**

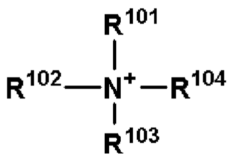

**( 2-2 )**

wherein X represents a monovalent alkali metal selected from lithium, sodium, potassium, and cesium, $R^{101}$, $R^{102}$, $R^{103}$, and $R^{104}$ each represent a hydrogen atom, a linear, branched, or cyclic alkyl group, alkenyl group, oxoalkyl group, or oxoalkenyl group having 1 to 12 carbon atoms, an aryl group having 6 to 20 carbon atoms, or an aralkyl group or aryloxoalkyl group having 7 to 12 carbon atoms, part or all of hydrogen atoms of these groups optionally being substituted with an alkoxy group or a hydroxy group and the groups optionally containing a hetero atom, $R^{101}$ and $R^{102}$, $R^{103}$ and $R^{104}$, and $R^{101}$, $R^{102}$, and $R^{104}$ optionally form a ring, and when a ring is formed, $R^{101}$ and $R^{102}$, $R^{103}$ and $R^{104}$, and $R^{101}$, $R^{102}$, and $R^{104}$ represent an alkylene group having 3 to 12 carbon atoms and optionally containing a hetero atom or represent a group including a heteroaromatic ring having the nitrogen atom in the formula in the ring, and $R^{101}$ and $R^{102}$ are optionally combined to form a group that is bonded with the nitrogen atom in the formula by a double bond, $R^{101}$ and $R^{102}$ optionally containing a hetero atom in this case.

**2.** The conductive polymer composition according to claim 1, wherein the acidic group is a sulfo group.

**3.** The conductive polymer composition according to claim 1, wherein the component (B) is contained in an amount

of 1 part by mass to 150 parts by mass based on 100 parts by mass of the component (A).

**4.** The conductive polymer composition according to claim 1, further comprising (C) a nonionic surfactant.

**5.** The conductive polymer composition according to claim 4, wherein the component (C) is contained in an amount of 0.1 parts by mass to 10 parts by mass based on 100 parts by mass of the component (A).

**6.** The conductive polymer composition according to claim 1, further comprising (D) a water-soluble polymer.

**7.** The conductive polymer composition according to claim 6, wherein the component (D) is contained in an amount of 30 parts by mass to 150 parts by mass based on 100 parts by mass of the component (A).

**8.** A coated product comprising a film of the conductive polymer composition according to any one of claims 1 to 7 formed on a body to be processed.

**9.** The coated product according to claim 8, wherein the body to be processed is a substrate comprising a chemically-amplified resist film.

**10.** The coated product according to claim 9, wherein the body to be processed is a substrate for obtaining a resist pattern by pattern irradiation using an electron beam.

**11.** The coated product according to claim 9, wherein the body to be processed is a substrate comprising a chemically-amplified electron beam resist film having a sensitivity of 20 $\mu C/cm^2$ or more.

**12.** The coated product according to claim 10, wherein the body to be processed is a substrate comprising a chemically-amplified electron beam resist film having a sensitivity of 20 $\mu C/cm^2$ or more.

**13.** A patterning process comprising the steps of:

forming an antistatic film on a resist film of a substrate provided with a chemically-amplified resist film by using the conductive polymer composition according to any one of claims 1 to 7;
performing pattern irradiation by using an electron beam; and
developing the substrate by using $H_20$ or an alkaline developer to obtain a resist pattern.

Europäisches Patentamt
European Patent Office
Office européen des brevets

# EUROPEAN SEARCH REPORT

Application Number
EP 23 21 2936

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2021/261765 A1 (NAKANO SAKI [JP] ET AL) 26 August 2021 (2021-08-26)<br>* paragraph [0339] - paragraph [0345]; example 1 * | 1-3<br>4-13 | INV.<br>C08G73/02<br>C08K5/09<br>C08K5/19<br>C08L39/06<br>C08L79/02<br>G03F7/00 |
| X | US 2021/005343 A1 (MAKIGAWA SAKI [JP] ET AL) 7 January 2021 (2021-01-07)<br>* example 1 *<br>* paragraphs [0288], [0341], [0284] * | 1-7 | |
| X<br>A | CN 108 948 739 A (CHENGDU NEW KELI CHEMICAL TECH CO LTD)<br>7 December 2018 (2018-12-07)<br>* paragraph [0025] - paragraph [0028]; example 1 * | 1-12<br>13 | |
| X | US 5 560 870 A (WATANABE KEIJI [JP] ET AL) 1 October 1996 (1996-10-01)<br>* column 11 - column 12; example 1 *<br>* column 8, line 32 * | 1-13 | |

TECHNICAL FIELDS SEARCHED (IPC)

C08K
G03F
C08F
C08G
C08L

The present search report has been drawn up for all claims

1

| Place of search | Date of completion of the search | Examiner |
|---|---|---|
| Munich | 28 March 2024 | Wohnhaas, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 21 2936

This annex lists the patent family members relating to the patent documents cited in the above-mentioned European search report. The members are as contained in the European Patent Office EDP file on
The European Patent Office is in no way liable for these particulars which are merely given for the purpose of information.

28-03-2024

| Patent document cited in search report | Publication date | Patent family member(s) | Publication date |
|---|---|---|---|
| US 2021261765 A1 | 26-08-2021 | CN 112996856 A | 18-06-2021 |
| | | EP 3882314 A1 | 22-09-2021 |
| | | JP 2023073265 A | 25-05-2023 |
| | | JP WO2020100791 A1 | 27-09-2021 |
| | | KR 20210068100 A | 08-06-2021 |
| | | TW 202024183 A | 01-07-2020 |
| | | US 2021261765 A1 | 26-08-2021 |
| | | WO 2020100791 A1 | 22-05-2020 |
| US 2021005343 A1 | 07-01-2021 | CN 111819637 A | 23-10-2020 |
| | | EP 3767639 A1 | 20-01-2021 |
| | | JP 7424283 B2 | 30-01-2024 |
| | | JP WO2019177096 A1 | 25-03-2021 |
| | | KR 20200131227 A | 23-11-2020 |
| | | TW 201938643 A | 01-10-2019 |
| | | TW 202344565 A | 16-11-2023 |
| | | US 2021005343 A1 | 07-01-2021 |
| | | WO 2019177096 A1 | 19-09-2019 |
| CN 108948739 A | 07-12-2018 | NONE | |
| US 5560870 A | 01-10-1996 | JP 3112745 B2 | 27-11-2000 |
| | | JP H063813 A | 14-01-1994 |
| | | US 5560870 A | 01-10-1996 |
| | | US 5721091 A | 24-02-1998 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2902727 B
- US 5370825 A
- JP 2014009342 A
- JP 3631910 B
- JP 2017039927 A
- JP 7108565 B
- JP 3154460 B
- JP 2959968 B